# EUROPEAN PATENT APPLICATION

(11) **EP 4 318 617 A1**
(43) Date of publication of application: **07.02.2024**
(21) Application number: 22779344.5
(22) Date of filing: 06.01.2022
(51) Int. Cl.: H01L 35/32, G06F 3/01

(54) **HAPTIC SENSATION PRESENTATION DEVICE, HAPTIC SENSATION PRESENTATION METHOD, AND PROGRAM**

(30) Priority: 29.03.2021 JP 2021054582
(71) Applicant: Sony Group Corporation, Tokyo 108-0075 (JP)
(72) Inventor: ORIHASHI, Masaki, Tokyo 108-0075 (JP); SATO, Masahiro, Tokyo 108-0075 (JP)
(74) Representative: D Young & Co LLP
(86) International application number: PCT/JP2022/000217
(87) International publication number: WO 2022/209111

(57) **Abstract**

[Object] To provide a technology capable of presenting a variety of tactile senses to a user.

[Solving Means] A tactile presentation apparatus according to the present technology includes a support, an expansion film, a thermoelectric conversion element, and a drive unit. The expansion film forms a space for retaining a fluid between the expansion film and the support. The thermoelectric conversion element includes a plurality of thermoelectric conversion elements arranged on a surface of the expansion film, the surface being located on a side of the support. The drive unit controls inflow/outflow of the fluid.

## Description

### Technical Field

The present technology relates to a tactile presentation apparatus, a tactile presentation method, and a program for presenting a tactile sense to a user.

### Background Art

Conventionally, there are known various tactile presentation apparatuses for presenting a tactile sense to a user.

For example, Patent Literature 1 below has disclosed a transducer for applying stimulation to a user, in which a Peltier device for changing the temperature is arranged on a pneumatically inflatable bladder. This transducer lifts the Peltier device through the inflatable bladder, presents a pressure force to a finger, and provides a stiff surface of the Peltier device to skin.

### Citation List

### Patent Literature

Patent Literature 1: Japanese Unexamined
Patent Application Publication No. 2018-528046

### Disclosure of Invention

### Technical Problem

In the above-mentioned field, it is desirable to provide a technology capable of presenting a variety of tactile senses to a user.

In view of the above-mentioned circumstances, it is an objective of the present technology to provide a technology capable of presenting a variety of tactile senses to a user.

### Solution to Problem

A tactile presentation apparatus according to the present technology includes a support, an expansion film, a thermoelectric conversion element, and a drive unit.

The expansion film forms a space for retaining a fluid between the expansion film and the support.

The thermoelectric conversion element includes a plurality of thermoelectric conversion elements arranged on a surface of the expansion film, the surface being located on a side of the support.

The drive unit controls inflow/outflow of the fluid.

With such a configuration, thermal stimulation such as a pressure sensation and a stiffness sensation by expansion of the expansion film and thermal stimulation by the thermoelectric conversion elements can be applied in a wide presentation area. A variety of tactile presentation can be thus achieved.

The expansion film may include a first expansion film and a second expansion film positioned closer to the support than the first expansion film, the space may be formed between the second expansion film and the support, and the thermoelectric conversion elements may be arranged on a surface of the first expansion film on the side of the support.

At least one of the plurality of thermoelectric conversion elements may have a different contact area with the expansion film from a contact area of each of other thermoelectric conversion elements with the expansion film.

The expansion film may include a plurality of expansion films.

The tactile presentation apparatus may further include at least one of a thermal sensor arranged on the expansion film on which the thermoelectric conversion elements are arranged, a distance sensor arranged in the space, or an air pressure sensor arranged in the space.

The expansion film may have thermal conductivity of 0.2 W/mK or more.

The plurality of thermoelectric conversion elements may be individually controlled.

The drive unit may be controlled to cause the fluid to flow in the space after driving the thermoelectric conversion element.

The thermoelectric conversion element may be driven at a temperature rise/temperature drop rate changed in a range of 0 ±10 °C/sec.

The tactile presentation apparatus may be arranged so that the expansion film is held in contact with skin of a user, and
the thermoelectric conversion element may be controlled so that a temperature of the thermoelectric conversion element is increased to an arbitrary temperature at a first temperature rise rate and then the temperature of the thermoelectric conversion element is lowered at a speed equal to or lower than 1/2 of the first temperature rise rate, and the temperature of the thermoelectric conversion element is increased after the temperature of the thermoelectric conversion element becomes in a range of a skin temperature of the user ±1°C.

The tactile presentation apparatus may be arranged so that the expansion film is held in contact with skin of a user, and
the thermoelectric conversion element may be controlled so that a temperature of the thermoelectric conversion element is lowered to an arbitrary temperature at a first temperature drop rate and then the temperature of the thermoelectric conversion element is increased at a speed equal to or lower than 1/2 of the first temperature drop rate, and the temperature of the thermoelectric conversion element is lowered after the temperature of the thermoelectric conversion element becomes in a range of a skin temperature of the user ±1°C.

The thermoelectric conversion element may be driven to apply thermal stimulation according to a video displayed to a user who wears the tactile presentation apparatus.

The thermoelectric conversion element may be driven using a control pattern of the thermoelectric conversion element for each type of thermal stimulation expressed by the thermoelectric conversion element, the control pattern being prepared in advance.

A tactile presentation method according to the present technology includes controlling driving of a plurality of thermoelectric conversion elements arranged on a surface of an expansion film that forms a space for retaining a fluid between the expansion film and a support and inflow/outflow of the fluid, the surface being located on a side of the support.

A program according to the present technology causes a computer to execute processing including controlling driving of a plurality of thermoelectric conversion elements arranged on a surface of an expansion film that forms a space for retaining a fluid between the expansion film and a support and inflow/outflow of the fluid, the surface being located on a side of the support.

### Brief Description of Drawings

[Fig. 1] A schematic cross-sectional view and a schematic plan view showing a configuration of a tactile presentation apparatus according to a first embodiment of the present technology.
[Fig. 2] A block diagram showing an internal control configuration of each of tactile presentation apparatuses according to first to third embodiments and a diagram showing a control configuration of a thermoelectric conversion element.
[Fig. 3] A view describing an operation principle of the thermoelectric conversion element.
[Fig. 4] A schematic view showing an operation example during the use of the tactile presentation apparatus in Fig. 1.
[Fig. 5] A schematic cross-sectional view showing a configuration and an example of the operation of the tactile presentation apparatus according to the second embodiment.
[Fig. 6] A schematic cross-sectional view showing a configuration and an example of the operation of the tactile presentation apparatus according to the third embodiment.
[Fig. 7] A schematic plan view showing a configuration example of the tactile presentation apparatus according to the third embodiment.
[Fig. 8] A schematic cross-sectional view showing a configuration example of a tactile presentation apparatus according to a fourth embodiment.
[Fig. 9] A view describing an application example of the tactile presentation apparatus.
[Fig. 10] A view showing a use example of the tactile presentation apparatus in Fig. 9.
[Fig. 11] A functional block diagram showing a control configuration of the tactile presentation apparatus in Fig. 9.
[Fig. 12] A view showing another application example of the tactile presentation apparatus.
[Fig. 13] A view showing still another application example of the tactile presentation apparatus.
[Fig. 14] A functional block diagram showing a control configuration of the tactile presentation apparatus in Fig. 13.
[Fig. 15] A view showing still another application example of the tactile presentation apparatus.
[Fig. 16] A view showing still another application example of the tactile presentation apparatus.
[Fig. 17] A view showing still another application example of the tactile presentation apparatus.
[Fig. 18] A view showing arrangement examples of thermoelectric conversion elements in the tactile presentation apparatus.
[Fig. 19] A diagram for describing a favorable contact area of the thermoelectric conversion element with an expansion film in the tactile presentation apparatus.
[Fig. 20] A diagram for describing a control example of the thermoelectric conversion elements in the tactile presentation apparatus.
[Fig. 21] A diagram for describing another control example of the thermoelectric conversion elements in the tactile presentation apparatus.
[Fig. 22] A diagram for describing still another control example of the thermoelectric conversion elements in the tactile presentation apparatus.
[Fig. 23] A diagram for describing still another control example of the thermoelectric conversion elements in the tactile presentation apparatus.
[Fig. 24] A diagram for describing still another control example of the thermoelectric conversion elements in the tactile presentation apparatus.
[Fig. 25] A flow chart showing a basic tactile presentation method in the tactile presentation apparatus.
[Fig. 26] A flow chart showing a control method for the thermoelectric conversion elements in the tactile presentation apparatus according to Presentation Example 1.
[Fig. 27] A flow chart showing a control method for the thermoelectric conversion elements in the tactile presentation apparatus according to Presentation Example 2.
[Fig. 28] A flow chart showing a control method for the thermoelectric conversion elements in the tactile presentation apparatus according to Presentation Example 3.
[Fig. 29] A schematic cross-sectional view and a schematic plan view of a modified example of the tactile presentation apparatus.
[Fig. 30] A schematic cross-sectional view and a schematic plan view of another modified example of the tactile presentation apparatus.
[Fig. 31] A perspective view and a schematic cross-sectional view describing a structure example of the thermoelectric conversion element.
[Fig. 32] A perspective view and a schematic cross-sectional view describing another structure example of the thermoelectric conversion element.

Mode(s) for Carrying Out the Invention

Hereinafter, embodiments according to the present technology will be described with reference to the drawings. In the description below, similar configurations will be denoted by similar reference signs and descriptions of aforementioned configurations will be omitted sometimes.

### <First Embodiment>

### [Overall Configuration and Configurations of Respective Units]

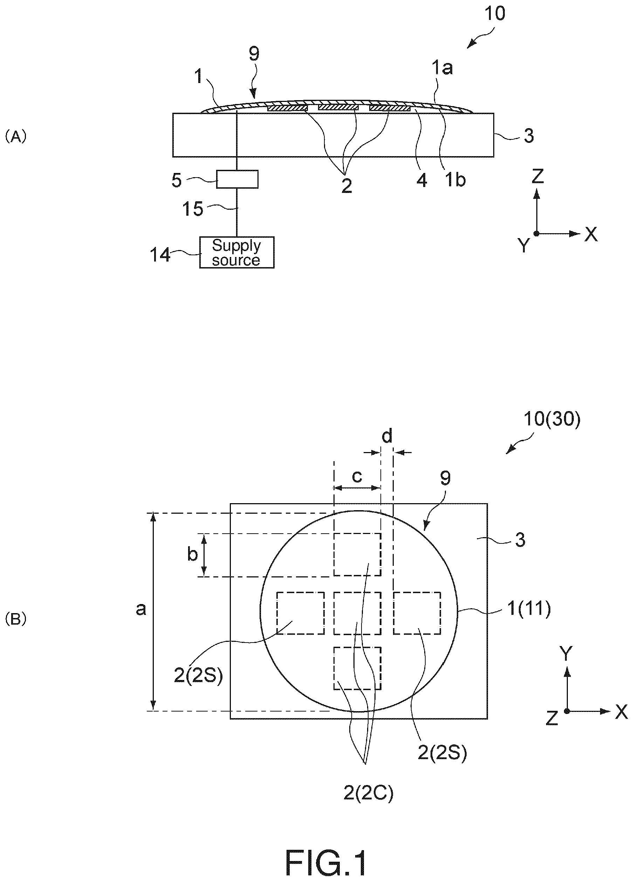

Fig. 1 (A) is a schematic cross-sectional view showing a configuration of a tactile presentation apparatus 10 according to a first embodiment of the present technology. Fig. 1 (B) is a schematic plan view of the tactile presentation apparatus 10 in Fig. 1 (A) as viewed from above. In the figure, a thickness direction of the tactile presentation apparatus 10 is a Z-axis and axes orthogonal to the Z-axis are an X-axis and a Y-axis. In the specification, a state as the tactile presentation apparatus 10 is viewed from above in the Z-axis direction will be referred to as a planar view. Moreover, a side closer to the skin of the user will be sometimes referred to as an upper or skin side and its opposite side will be sometimes referred to as a lower or non-skin side in a state in which the tactile presentation apparatus is used.

The tactile presentation apparatus presents a tactile sense such as a pressure sensation, a stiffness sensation, and a thermal sensation to skin of a user in such a manner that an expansion film to be described later that constitutes a part of the tactile presentation apparatus is held in contact with the skin. Although the description will be given exemplifying a hand finger tip as a tactile presentation target in the present embodiment, the present technology is not limited to the finger tip. Other examples will be described later.

As shown in Fig. 1, the tactile presentation apparatus 10 includes a support 3 and a presentation unit 9.

The support 3 is a base having a surface with such a size that the entire finger tip can be placed on it, for example. For the use, the support 3 is set on, for example, a desk having a horizontal surface. The user places the finger tip on the presentation unit 9 for using it.

The presentation unit 9 presents a tactile sense such as a pressure sensation, a stiffness sensation, and a thermal sensation through pressure stimulation and thermal stimulation.

The presentation unit 9 includes a space 4 that allows a fluid to flow in or out of it, an expansion film 1 provided covering the space 4, and a plurality of thermoelectric conversion elements 2 arranged on a second surface 1b of the expansion film 1. Moreover, the presentation unit 9 includes a supply source 14 that supplies a fluid, an actuator 5 as a drive unit that controls the inflow/outflow of the fluid in or out of the space 4 by its driving, and a pipe 15 connecting the space 4 to the supply source 14.

In the example shown in Fig. 1, the expansion film 1 has a plane shape that is a substantially perfect circle shape. The circumferential portion of the expansion film 1 is fixed to the support 3. Providing the expansion film 1 to the support 3 forms the space 4 for retaining a fluid between the expansion film 1 and the support 3.

It should be noted that the shape of the expansion film 1 is not limited to the circle shape, and can be set as appropriate depending on an application of the tactile presentation apparatus and a tactile presentation target site.

The fluid retained in the space 4 may be gas such as air and helium or may be a liquid such as water and oil, for example. It should be noted that the type of fluid is not particularly limited, and various fluids can be used. It should be noted that the thermoelectric conversion elements 2 may be subjected to waterproofing treatment if the thermoelectric conversion elements 2 are used in a liquid as the fluid.

The expansion film 1 has a first surface 1a and the second surface 1b. In the tactile presentation apparatus 10, the expansion film 1 is exposed. The first surface 1a is a skin side surface that is held in contact with the skin of the user during the use of the tactile presentation apparatus 10. The second surface 1b is a non-skin side surface on the opposite side of the first surface 1a. The second surface 1b is a surface positioned on the side of the support 3.

The expansion film 1 is configured in the form of a thin film. The expansion film 1 is configured to be deformable in accordance with the inflow/outflow of the fluid in or out of the space 4. The material used for the expansion film 1 can be various rubbers, e.g., typically a silicon rubber, a urethane rubber, an ethylene propylene diene monomer rubber (EPDM), a natural rubber in consideration of elasticity. It should be noted that the expansion film 1 only needs to be deformable (capable of expansion and contraction) in accordance with the inflow/outflow of the fluid in or out of the space 4, and may be constituted by a material other than the rubber.

The expansion film 1 is capable of expanding (projecting) outward by stretching in accordance with the inflow of the fluid in the space 4. This expansion of the expansion film 1 applies pressure stimulation to the finger tip of the user. Moreover, the expansion film 1 is capable of contracting from the outward and expanding state returning to the original state by contracting in accordance with the outflow of the fluid from the space 4.

Controlling the inflow/outflow of the fluid in or out of the space 4 in this manner can apply pressure stimulation to the skin of the user in contact with the expansion film 1 and present a tactile sense such as a pressure sensation and a stiffness sensation. For example, adjusting the pressure of the space 4 can adjust the stiffness to be presented.

The actuator 5 is attached to the pipe 15 that connects the space 4 to the supply source 14. The actuator 5 controls the inflow/outflow of the fluid in or out of the space 4 by its driving. The actuator 5 is constituted by various actuators 5, e.g., a pump, a fan, and a blower. However, any configuration can be employed.

The supply source 14 is capable of supplying a fluid into the space 4 via the pipe 15. The supply source 14 may be a compression air pressure source such as an air compressor in a case where the air is used as the fluid, for example. Alternatively, the supply source 14 may be, for example, a tank capable of storing the fluid in a case where a liquid such as water or a special gas (e.g., helium) such as the air is used as the fluid.

The thermoelectric conversion elements 2 are typically Peltier devices.

The tactile presentation apparatus 10 applies thermal stimulation to the user and presents a warm or cold sensation with heat in heat dissipation or heat absorption of the thermoelectric conversion element.

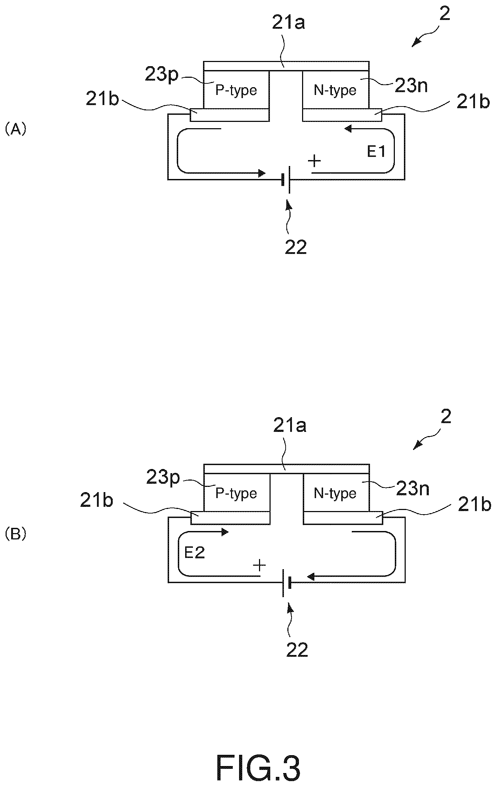

Fig. 3 is an operation explanatory diagram showing the principle of the Peltier device (thermoelectric conversion element). In the thermoelectric conversion element 2, a P-type thermoelectric semiconductor 23p and an N-type thermoelectric semiconductor 23n are joined with an electrode 21a and an electrode 21b and a power supply 22 that causes direct current to flow through the P-type thermoelectric semiconductor 23p and the N-type thermoelectric semiconductor 23n is connected to the electrode 21b.

As to the thermoelectric conversion element 2, flowing a direct current from the N-type thermoelectric semiconductor 23n to the P-type thermoelectric semiconductor 23p as shown as the arrows E1 in Fig. 3 (A) transports heat from the side of the electrode 21a to the side of the electrode 21b, such that the side of the electrode 21a is cooled by heat absorption and the side of the electrode 21b is heated by heat dissipation.

In this regard, flowing a direct current from the P-type thermoelectric semiconductor 23p to the N-type thermoelectric semiconductor 23n as shown in the arrows E2 in Fig. 3 (B) transports heat from the side of the electrode 21b to the side of the electrode 21a, such that the side of the electrode 21b is cooled by heat absorption and the side of the electrode 21a is heated by heat dissipation.

Changing the orientation of the supplied current in this manner can switch heating and cooling of the thermoelectric conversion elements 2.

The plurality of thermoelectric conversion elements 2 is arranged on the side of the second surface 1b of the expansion film 1. The thermoelectric conversion elements 2 each have typically a plane shape in the form of a rectangular thin plate. It should be noted that the plane shape is not limited to the rectangular shape, and it can be a desired shape such as a circular shape.

In the example shown in Fig. 1 (B), five thermoelectric conversion elements 2 with the same dimension are arranged. One of the plurality of thermoelectric conversion elements 2 is positioned at the center of the expansion film 1 in a planar view. In Fig. 1 (B), other four thermoelectric conversion elements 2 are positioned on upper and lower sides in the Y-axis direction and left- and right-hand sides in the X-axis direction of the thermoelectric conversion element 2 positioned at substantially the center. The plurality of thermoelectric conversion elements 2 is positioned spaced apart from each other.

During the use of the tactile presentation apparatus 10, the finger tip of the user is placed on the first surface 1a of the expansion film 1 so that the direction in which the finger extends is substantially parallel to the Y-axis direction.

In Fig. 1 (B), three thermoelectric conversion elements positioned at the center portion of the expansion film 1 in the X-axis direction are denoted by the reference sign 2C. Two thermoelectric conversion elements positioned in side portions positioned on the left- and right-hand sides of the center portion of the expansion film 1 in the X-axis direction are denoted by the reference sign 2S. Unless it is particularly necessary to distinguish between the thermoelectric conversion elements 2C and 2S, they will be referred to as thermoelectric conversion elements 2.

It should be noted that the number of thermoelectric conversion elements 2 and the arrangement of the thermoelectric conversion elements 2 are not limited thereto. Specific dimension, arrangement, and the like of the thermoelectric conversion elements 2 will be described later.

The thermoelectric conversion elements 2 are arranged on the second surface 1b of the expansion film 1, which is the non-skin side surface. Therefore, during the use of the tactile presentation apparatus 10, a finger tip of a user U indirectly touches the thermoelectric conversion elements 2 via the expansion film 1.

Here, in a case where the thermoelectric conversion elements 2 are arranged on the first surface 1a of the expansion film 1, a hard and flat texture of the thermoelectric conversion elements 2 is presented to the user U. Therefore, even when a hard or soft texture is presented by pressure stimulation by expansion of the expansion film 1, the presence of the thermoelectric conversion elements 2 held in direct contact with the finger tip of the user U makes it difficult to sufficiently present such a texture.

In this regard, in the present embodiment, the thermoelectric conversion elements 2 are arranged on the second surface 1b of the expansion film 1, which is the non-skin side surface. Therefore, arranging the thermoelectric conversion elements 2 on the side of the first surface 1a does not deteriorate the presentation of a hard or soft texture by pressure stimulation.

In this manner, arranging the thermoelectric conversion elements 2 on the second surface 1b of the expansion film 1 achieves the structure in which the finger of the user U does not directly touch the thermoelectric conversion elements 2. A variety of tactile presentation can be thus achieved.

Moreover, the thermoelectric conversion elements 2 are arranged on the expansion film 1, which is held in direct contact with the skin of the user during the use of the tactile presentation apparatus 10. Therefore, thermal presentation by the thermoelectric conversion elements 2 to the skin of the user can be rapidly performed. That is, the heat use efficiency of heat dissipation and heat absorption by the thermoelectric conversion elements 2 can be made favorable, and thermal presentation to the user U can be achieved with small temperature increases or decreases in the thermoelectric conversion elements 2. The Peltier devices as the thermoelectric conversion elements consume much power. Therefore, arranging the thermoelectric conversion elements 2 on the expansion film 1 that is held in direct contact with the skin of the user is favorable in view of the heat use efficiency as well as power consumption.

The thermoelectric conversion elements 2 are fixed and arranged on the second surface 1b of the expansion film 1 with an adhesion (not shown). The adhesion is applied, for example, using the entire surfaces (upper surfaces) of the thermoelectric conversion elements 2 on an adhesion application side as application regions. An adhesion application pattern is not particularly limited. For example, in the application regions, the adhesion may be formed in a separate application pattern with both application portions and non-application portions like a spiral form or an application pattern without non-application portions in the entire application regions may be formed. In the description below, adhesion application regions mean regions surrounding the entire adhesion application portions and may include the non-application portions.

It should be noted that the adhesion may be formed on partial regions of the surfaces of the thermoelectric conversion elements 2 on the application side as the application regions.

Favorably, the application regions in the thermoelectric conversion elements 2 are set to be larger, i.e., the contact area of the thermoelectric conversion elements 2 with the expansion film 1 is set to be larger for the purpose of preventing the thermoelectric conversion elements 2 from being pealed off from the expansion film 1 and increasing the heat use efficiency of the thermoelectric conversion elements 2. Here, the adhesive is, as an example, formed on the entire surfaces of the thermoelectric conversion elements 2 as the application regions.

The plurality of thermoelectric conversion elements 2 is separately arranged, spaced apart from each other. Accordingly, the second surface 1b of the expansion film 1 includes thermoelectric conversion element adhesion regions in which the thermoelectric conversion elements 2 are adhered with an adhesion and thermoelectric conversion element non-adhesion regions in which the thermoelectric conversion elements 2 are not adhered.

The adhesion of the thermoelectric conversion elements 2 to the expansion film 1 interferes with expansion of the expansion film 1 in the thermoelectric conversion element adhesion regions of the expansion film 1.

On the other hand, nothing interferes with expansion of the expansion film 1 in the thermoelectric conversion element non-adhesion regions of the expansion film 1.

In the tactile presentation apparatus 10, arranging the plurality of thermoelectric conversion elements 2 spaced apart from each other in this manner achieves the form in which the thermoelectric conversion element non-adhesion regions that do not interfere with expansion of the expansion film 1 are distributed in the entire region of the expansion film 1. Accordingly, in a wide tactile presentation range, pressure stimulation by expansion of the expansion film can be applied and thermal stimulation with piezoelectric conversion elements can also be applied.

It should be noted that the thermoelectric conversion elements 2 may be arranged in contact with each other rather than separately arranging the thermoelectric conversion elements 2 and the same applies to other embodiments to be described later.

The thermoelectric conversion element adhesion regions on the expansion film 1 correspond to adhesion application regions on the thermoelectric conversion elements 2.

In a case where the adhesion is formed on partial regions of the surfaces of the thermoelectric conversion elements 2 on the application side as the application regions, the expansion film 1 is not adhered to the thermoelectric conversion elements 2 in regions other than the adhesion application regions. Thus, the regions can be regions that do not interfere with the expansion. For example, in a case where the adhesion application regions on the thermoelectric conversion elements 2 are set to be rectangular shapes each of which is smaller in size than each of the plane shapes of the thermoelectric conversion elements 2, the smaller rectangular application regions are the thermoelectric conversion element adhesion regions on the thermoelectric conversion elements 2 while frame-like portions surrounding them are the thermoelectric conversion element non-adhesion regions. In a case of such an adhesion shape, for example, in a case where the plurality of thermoelectric conversion elements is arranged in contact with each other, regions near the boundary between the thermoelectric conversion elements adjacent to each other can be the thermoelectric conversion element non-adhesion regions. Thus, even in a case where the plurality of thermoelectric conversion elements is arranged in contact with each other, a configuration in which the regions that do not interfere with the expansion due to the presence of the thermoelectric conversion elements are distributed in the surface of the expansion film can be made by setting the adhesion application regions.

Thermal stimulation to a thermal presentation target region site (hand finger tip in the present embodiment) may be performed by simultaneously controlling the plurality of thermoelectric conversion elements 2 at once. Moreover, the plurality of thermoelectric conversion elements 2 may be individually controlled. Control examples will be described later.

As described above, separately arranging the plurality of thermoelectric conversion elements 2 on the second surface 1b of the expansion film 1 in the tactile presentation apparatus 10 can achieve a variety of tactile presentation by pressure stimulation and thermal stimulation and can also reduce the power consumption.

Here, a thin resistance heater can be used for increasing the temperature. However, the use of the thermoelectric conversion element (Peltier device) can more quickly present a temperature change with lower power consumption as compared to the thin resistance heater. Moreover, since the thin resistance heater lowers the temperature by natural heat dissipation, it takes time to lower the temperature. On the other hand, since the thermoelectric conversion element (Peltier device) is capable of cooling, the use of the thermoelectric conversion element (Peltier device) can also easily control lowering of the temperature and can rapidly present a desired temperature.

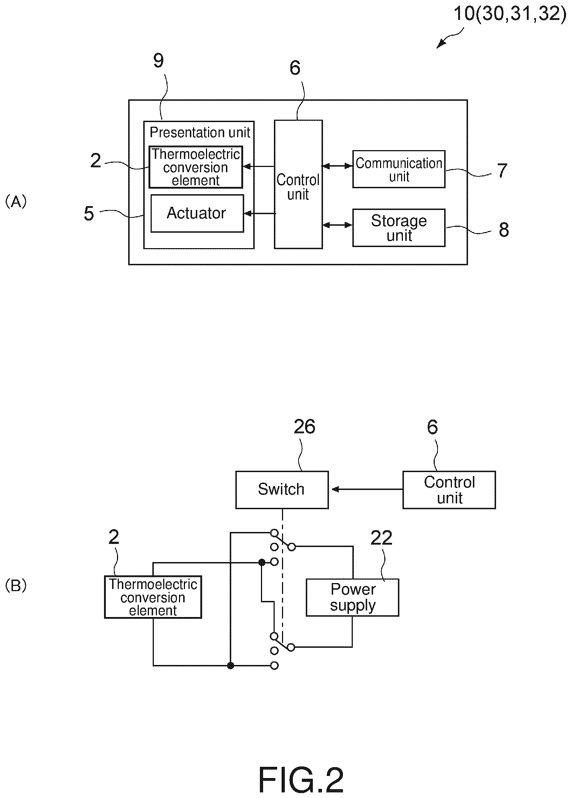

Fig. 2 (A) is a block diagram showing a configuration of the tactile presentation apparatus 10. Fig. 2 (B) is a diagram for describing some configurations of the tactile presentation apparatus 10 in more detail and is a diagram showing a control configuration of the thermoelectric conversion element.

As shown in Fig. 2, the tactile presentation apparatus 10 includes a control unit 6, the thermoelectric conversion elements 2 and the actuator 5 in the presentation unit 9, a communication unit 7, and a storage unit 8.

The control unit 6 executes various arithmetic operations on the basis of various programs stored in the storage unit 8 and comprehensively controls the respective units of the tactile presentation apparatus 10.

The control unit 6 is achieved by hardware or a combination of hardware and software. The hardware is configured as a part or whole of the control unit 6. Examples of this hardware can include a central processing unit (CPU), a digital signal processor (DSP), a field programmable gate array (FPGA), an application specific integrated circuit (ASIC), or a combination of two or more of them.

The actuator 5 is a part of the presentation unit 9 and is driven under the control of the control unit 6 to control the inflow/outflow of the fluid in or out of the space 4.

The thermoelectric conversion element 2 is a part of the presentation unit 9 and is driven under the control of the control unit 6 to switch heating and cooling.

As shown in Fig. 2 (B), the tactile presentation apparatus 10 includes the direct-current power supply 22 that drives the thermoelectric conversion elements 2 and a switch 26 that switches the current orientation. The control unit 6 controls the switch 26 on the basis of a control signal based on tactile presentation-related information (to be described later) and switches heating and cooling of the thermoelectric conversion elements 2. The power supply 22 is a battery, for example.

It should be noted that the example in which the tactile presentation apparatus 10 includes the power supply 22 is described here, though not limited thereto. For example, the tactile presentation apparatus may be connected to an external apparatus with a wire. The external apparatus may include current rectifier and buck converter/boost converter circuits. The piezoelectric conversion elements may be supplied with power from the external apparatus. A switch provided in the external apparatus may switch the orientation of the supplied current.

The storage unit 8 includes various programs required for processing of the control unit 6, a nonvolatile memory for storing various types of data, and a volatile memory used as a work area for the control unit 6. It should be noted that the various programs may be read from a portable recording medium such as an optical disc and a semiconductor memory or may be downloaded from, for example, a server apparatus in a network.

The communication unit 7 is configured to be capable of communicating with other apparatuses, e.g., other tactile presentation apparatuses 10, in a wired or wireless manner. The tactile presentation apparatus 10 may directly communicate with the other apparatuses or may indirectly communicate with the other apparatuses via another apparatus such as a server apparatus in a network.

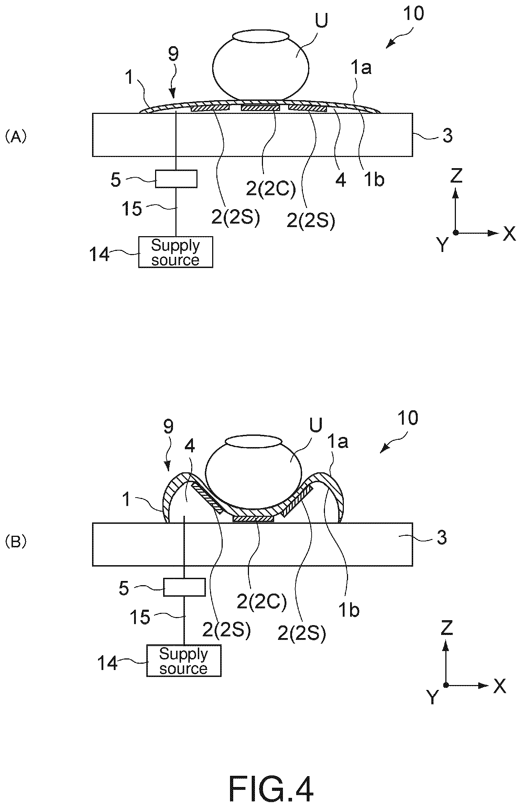

Next, an operation of the tactile presentation apparatus during the use will be described with reference to Fig. 4.

Fig. 4 (A) shows a state before the fluid flows in the space 4 in the tactile presentation apparatus.

Fig. 4 (B) shows a state after the fluid flows in the space 4 in the tactile presentation apparatus.

During the use, the finger is placed on the expansion film 1 so that the finger tip of the user U touches the expansion film 1 of the tactile presentation apparatus 10.

As shown in Fig. 4 (A), in a state in which the expansion film 1 has contracted before the inflow of the fluid, the abdomen of the finger tip of the user U is placed in contact with the three thermoelectric conversion elements 2C positioned at the center in the X-axis direction via the expansion film 1.

As shown in Fig. 4 (B), the entire expansion film 1 expands in a state in which the expansion film 1 has expanded after the inflow of the fluid, and the weight of the finger tip of the user U suppresses the expansion in the Z-axis direction at the center portion of the expansion film 1 in the X-axis direction. On the other hand, the side portions of the expansion film 1 in the X-axis direction expand upwards in the Z-axis direction. The expansion film 1 is generally deformed so as to hold the finger tip of the user U. As a result, the abdomen and the lateral portions of the finger of the user U are held in contact with the three thermoelectric conversion elements 2C positioned at the center portion in the X-axis direction and the two thermoelectric conversion elements 2S positioned at the side portions in the X-axis direction via the expansion film 1. The thermoelectric conversion elements 2 are adhered and fixed to the expansion film 1. Therefore, during expansion of the expansion film 1, the positions of the thermoelectric conversion elements 2 change with deformation of the expansion film 1. The expansion film 1 is deformed along the shape of the finger tip of the user U. Therefore, the thermoelectric conversion elements 2 are held in contact with the finger tip via the expansion film 1. Therefore, the thermoelectric conversion elements 2 have favorable heat use efficiency, and the thermal presentation can be effectively performed.

### <Second Embodiment>

### [Overall Configuration and Configurations of Respective Units]

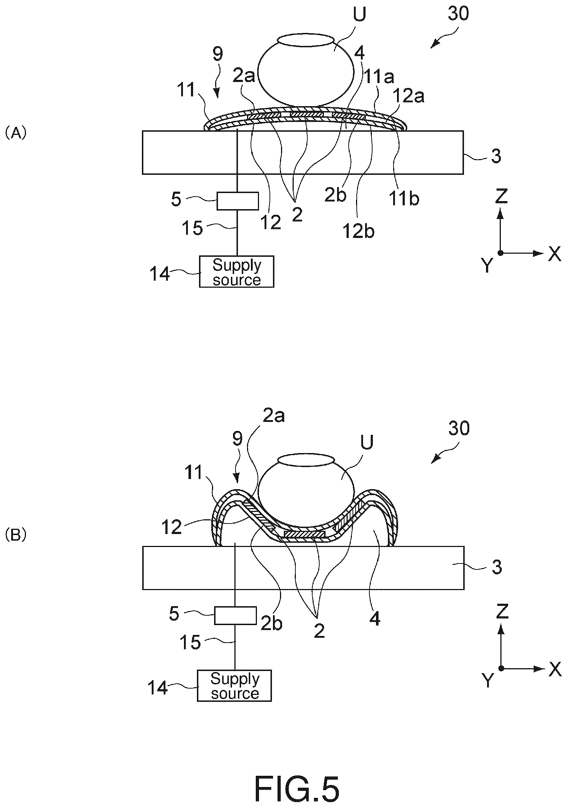

Fig. 5 is a schematic cross-sectional view showing a configuration of a tactile presentation apparatus 30 according to a second embodiment of the present technology and is a schematic view showing an operation example during the use. The present embodiment is different from the first embodiment in that two expansion films are provided.

The tactile presentation apparatus 30 presents a tactile sense such as a pressure sensation, a stiffness sensation, and a thermal sensation to the skin in such a manner that a first expansion film 11 that constitutes the tactile presentation apparatus 30 to be described later is held in contact with the skin of the user. Here, the tactile presentation target site is the hand finger tip as an example.

Fig. 5 (A) shows a state before the fluid flows in the space 4 in the tactile presentation apparatus 30.

Fig. 5 (B) shows a state after the fluid flows in the space 4 in the tactile presentation apparatus 30.

A configuration of the tactile presentation apparatus 30 will be described.

As shown in Fig. 5, the tactile presentation apparatus 30 includes a support 3 and a presentation unit 9. The presentation unit 9 presents a tactile sense to the finger tip of the user during the use.

The presentation unit 9 includes a space 4 that allows a fluid to flow in or out of it, a second expansion film 12 provided covering the space 4, a first expansion film 11 arranged on an upper side than the second expansion film 12, and a plurality of thermoelectric conversion elements 2 arranged on a second surface 11b of the first expansion film 11.

Moreover, the presentation unit 9 includes a supply source 14 that supplies a fluid, an actuator 5 as a drive unit that controls the inflow/outflow of the fluid in or out of the space 4 by its driving, and a pipe 15 connecting the space 4 to the supply source 14.

As shown in Fig. 1 (B), the first expansion film 11 has a plane shape that is a substantially perfect circle shape as in the first embodiment. Moreover, the arrangement of the plurality of thermoelectric conversion elements 2 arranged on the second surface 11b of the first expansion film 11 is similar to the arrangement in the first embodiment as shown in Fig. 1 (B).

The second expansion film 12 has substantially the same shape as the first expansion film 11 in a planar view.

The circumferential portions of the first expansion film 11 and the second expansion film 12 are fixed to the support 3. Providing the second expansion film 12 to the support 3 forms a space 4 for retaining a fluid between the second expansion film 12 and the support 3.

The first expansion film 11 has a first surface 11a and the second surface 11b. In the tactile presentation apparatus 30, the first expansion film 11 is exposed. The first surface 11a is a skin side surface that is held in contact with the skin of the user during the use of the tactile presentation apparatus 30. The second surface 11b is a non-skin side surface on the opposite side of the first surface 11a. The second surface 11b is a surface positioned on the side of the support 3.

The second expansion film 12 has a first surface 12a and a second surface 12b. In the tactile presentation apparatus 30, the second expansion film 12 is not exposed and is positioned on a lower side than the first expansion film 11. The first surface 12a is a skin side surface. The second surface 12b is a non-skin side surface on the opposite side of the first surface 12a. The second surface 12b is a surface positioned on the side of the support 3.

The first expansion film 11 and the second expansion film 12 are each configured in the form of a thin film. The first expansion film 11 and the second expansion film 12 are configured to be deformable by the inflow/outflow of the fluid in or out of the space 4. The material used for the first expansion film 11 and the second expansion film 12 can be various rubbers, e.g., typically a silicon rubber, a urethane rubber, an ethylene propylene diene monomer rubber (EPDM), a natural rubber in consideration of elasticity. It should be noted that the first expansion film 11 and the second expansion film 12 only need to be deformable (capable of expansion and contraction) in accordance with the inflow/outflow of the fluid in or out of the space 4, and may be constituted by a material other than the rubber.

The thermoelectric conversion elements 2 are positioned between the first expansion film 11 and the second expansion film 12.

The thermoelectric conversion element 2 has a first surface 2a that is a skin side surface and a second surface 2b that is a non-skin side surface.

The first surface 2a of each of the plurality of thermoelectric conversion elements 2 is arranged, adhered to the second surface 11b of the first expansion film 11 with an adhesion (not shown). In addition, the second surface 2b of each of the plurality of thermoelectric conversion elements 2 is arranged, adhered to the first surface 12a of the second expansion film 12 with an adhesion (not shown).

It should be noted that the example in which the second expansion film 12 is adhered to the thermoelectric conversion elements 2 with an adhesion is described here, they do not need to be adhered to each other with an adhesion.

The space between the first expansion film 11 and the second expansion film 12 and the space 4 between the second expansion film 12 and the support 3 are in an uncoupled state and spaces independent of each other.

The second expansion film 12 is capable of expanding (projecting) outward by stretching in accordance with the inflow of the fluid in the space 4. In addition, the first expansion film 11 adhered to the second expansion film 12 via the thermoelectric conversion elements 2 also expands with expansion of the second expansion film 12. The expansion of the first expansion film 11 and the second expansion film 12 presents a pressure sensation to the finger tip of the user.

Moreover, the second expansion film 12 is capable of contracting from the outward and expanding state returning to the original state by contracting in accordance with the outflow of the fluid from the space 4. In addition, the first expansion film 11 also contracts with contraction of the second expansion film 12.

The first expansion film 11 and the second expansion film 12 are adhered to each other via the thermoelectric conversion elements 2. Accordingly, the second expansion film 12 can support the thermoelectric conversion elements 2 even if the thermoelectric conversion elements 2 fall from the first expansion film 11. Thus, the thermal presentation can be continued. In addition, the second expansion film 12 functions as a heat dissipation portion that disperses heat moving from the thermoelectric conversion elements 2 and can rapidly perform desired thermal presentation.

In a case where the second expansion film 12 and the thermoelectric conversion elements 2 are not adhered to each other with an adhesion, the second expansion film 12 and the thermoelectric conversion elements 2 may be arranged in contact with each other or may be arranged without contact with each other in a state before the inflow of the fluid. The second expansion film 12 can support the thermoelectric conversion elements 2 even if the thermoelectric conversion elements 2 fall. Thus, the thermal presentation can be continued. Moreover, even in a case where the second expansion film 12 and the thermoelectric conversion elements 2 are arranged without contact with each other in a state before the inflow of the fluid, the fluid flowing in the space 4 causes the second expansion film 12 to expand so that it pushes up the thermoelectric conversion elements 2. Therefore, the second expansion film 12 and the thermoelectric conversion elements 2 are held in contact with each other. Accordingly, the second expansion film 12 can efficiently function as the heat dissipation portion and can rapidly perform desired thermal presentation.

Moreover, also in the present embodiment, the plurality of thermoelectric conversion elements 2 can be separately arranged, spaced apart from each other as in the first embodiment. Accordingly, the second surface 11b of the first expansion film 11 includes thermoelectric conversion element adhesion regions in which the thermoelectric conversion elements 2 are adhered with an adhesion and thermoelectric conversion element non-adhesion regions in which the thermoelectric conversion elements 2 are not adhered. Similarly, the first surface 12a of the second expansion film 12 includes thermoelectric conversion element adhesion regions in which the thermoelectric conversion elements 2 are adhered with an adhesion and thermoelectric conversion element non-adhesion regions in which the thermoelectric conversion elements 2 are not adhered.

The adhesion of the thermoelectric conversion elements 2 to the first expansion film 11 interferes with expansion of the first expansion film 11 in the thermoelectric conversion element adhesion regions of the first expansion film 11. The adhesion of the thermoelectric conversion elements 2 to the second expansion film 12 interferes with expansion of the second expansion film 12 in the thermoelectric conversion element adhesion regions of the second expansion film 12.

On the other hand, the presence of the thermoelectric conversion elements 2 does not interfere with expansion of the first expansion film 11 in the thermoelectric conversion element non-adhesion regions of the first expansion film 11. The presence of the thermoelectric conversion elements 2 does not interfere with expansion of the second expansion film 12 in the thermoelectric conversion element non-adhesion regions of the second expansion film 12.

Separately arranging the plurality of thermoelectric conversion elements 2 in the tactile presentation apparatus 30 in this manner achieves the form in which the thermoelectric conversion element non-adhesion regions that do not interfere with expansion of the first expansion film 11 and the second expansion film 12 are distributed in the entire regions of the first expansion film 11 and the second expansion film 12. Accordingly, in a wide tactile presentation range, pressure stimulation by expansion of the expansion film can be applied and thermal stimulation with the thermoelectric conversion elements can also be applied.

In addition, the thermoelectric conversion elements 2 are arranged on the second surface 11b of the first expansion film 11, which is the non-skin side surface, as in the first embodiment. Therefore, the finger tip of the user U indirectly touches the thermoelectric conversion elements 2 via the first expansion film 11 during the use of the tactile presentation apparatus 30. Accordingly, a hard and flat texture of the thermoelectric conversion elements 2 is not easily directly presented to the finger tip of the user. Thus, arranging the thermoelectric conversion elements 2 on the side of the first surface 11a does not deteriorate the presentation of a hard or soft texture by pressure stimulation.

In this manner, arranging the thermoelectric conversion elements 2 on the second surface 11b of the first expansion film 11 achieves the structure in which the finger of the user U does not directly touch the thermoelectric conversion elements 2. A variety of tactile presentation can be thus achieved.

Moreover, the thermoelectric conversion elements 2 are arranged on the first expansion film 11, which is held in direct contact with the skin of the user during the use of the tactile presentation apparatus 30. Therefore, thermal presentation by the thermoelectric conversion elements 2 to the skin of the user can be rapidly performed. That is, the heat use efficiency of heat dissipation and heat absorption by the thermoelectric conversion elements 2 can be made favorable, and thermal presentation to the user U can be achieved with small temperature increases or decreases in the thermoelectric conversion elements 2. Moreover, the power consumption can be reduced.

As described above, separately arranging the plurality of thermoelectric conversion elements 2 on the second surface 11b of the first expansion film 11 in the tactile presentation apparatus 30 can achieve a variety of tactile presentation by pressure stimulation and thermal stimulation and can also reduce the power consumption.

Fig. 2 (A) is a block diagram showing a configuration of the tactile presentation apparatus 30. Fig. 2 (B) is a diagram for describing some configurations of the tactile presentation apparatus 30 in more detail and is a diagram showing a control configuration of the thermoelectric conversion element.

As shown in Fig. 2, the tactile presentation apparatus 30 includes a control unit 6, the thermoelectric conversion elements 2 and the actuator 5 in the presentation unit 9, a communication unit 7, and a storage unit 8. The basic configuration is similar to the basic configuration of the first embodiment.

Next, an operation of the tactile presentation apparatus during the use will be described with reference to Fig. 5.

During the use, the finger is placed on the expansion film 11 so that the finger tip of the user U touches the first expansion film 11 of the tactile presentation apparatus 30.

As shown in Fig. 5 (A), in a state in which the first expansion film 11 and the second expansion film 12 have contracted before the inflow of the fluid, the abdomen of the finger tip of the user U is placed in contact with three thermoelectric conversion elements 2C positioned at the center in the X-axis direction via the first expansion film 11.

As shown in Fig. 5 (B), in the state the first expansion film 11 has expanded after the inflow of the fluid, the first expansion film 11 and the second expansion film 12 generally expand while the weight of the finger tip of the user U suppresses expansion in the Z-axis direction at the center portions of the first expansion film 11 and the second expansion film 12 in the X-axis direction. On the other hand, the side portions of the first expansion film 11 and the second expansion film 12 in the X-axis direction expand upwards in the Z-axis direction. The first expansion film 11 and the second expansion film 12 are generally deformed so as to hold the finger tip of the user U. As a result, the abdomen and the lateral portions of the finger of the user U are held in contact with the three thermoelectric conversion elements 2C positioned at the center portion in the X-axis direction and the two thermoelectric conversion elements 2S positioned at the side portions in the X-axis direction via the first expansion film 11. The thermoelectric conversion elements 2 are adhered and fixed to the first expansion film 11 and the second expansion film 12. Therefore, during expansion of the first expansion film 11 and the second expansion film 12, the positions of the thermoelectric conversion elements 2 change with deformation of the first expansion film 11 and the second expansion film 12. Therefore, the thermoelectric conversion elements 2 are held in contact with the finger tip via the first expansion film 11. Therefore, the thermoelectric conversion elements 2 have favorable heat use efficiency, and the thermal presentation can be effectively performed.

### <Third Embodiment>

### [Overall Configuration and Configurations of Respective Units]

The present embodiment is different from the first and second embodiments in that a plurality of spaces that allows the fluid to flow in/out of them are provided.

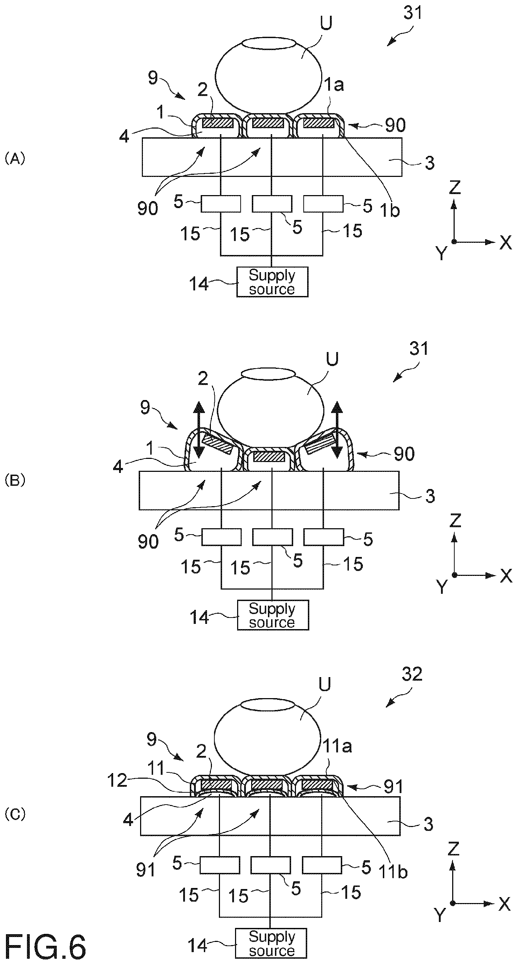

Fig. 6 (A) and (B) are schematic cross-sectional views showing a configuration of a tactile presentation apparatus 31 according to a third embodiment of the present technology and are schematic views showing an operation example during the use.

Fig. 6 (C) is a schematic cross-sectional view showing a configuration of a tactile presentation apparatus 32 according to the third embodiment of the present technology.

The tactile presentation apparatuses 31 and 32 each have a configuration in which the plurality of spaces that allows the fluid to flow in/out of them. The tactile presentation apparatus 31 has a single expansion film corresponding to each space as in the first embodiment. The tactile presentation apparatus 32 has two expansion films corresponding to each space as in the second embodiment.

The tactile presentation apparatus 31 (32) is configured so that an expansion film 1 (first expansion film 11) that constitutes a presentation unit 9 can be held in contact with the skin of the user. The tactile presentation apparatus 31 (32) presents a tactile sense such as a pressure sensation, a stiffness sensation, and a thermal sensation to the skin. Here, the tactile presentation target site is the hand finger tip as an example.

A configuration of the tactile presentation apparatus 31 will be described.

Fig. 6 (A) shows a state before the fluid flows in the space 4 in the tactile presentation apparatus 31.

Fig. 6 (B) shows a state after the fluid flows in the space 4 in the tactile presentation apparatus 31.

As shown in Fig. 6 (A) and (B), the tactile presentation apparatus 31 includes a support 3 and the presentation unit 9. The presentation unit 9 is constituted by a plurality of warm/cold expansion chambers 90. In this regard, the tactile presentation apparatuses 10 and 30 described above in the first and second embodiments have a single warm/cold expansion chamber.

Each of the warm/cold expansion chambers 90 includes a space 4 that allows a fluid to flow in or out of it, an expansion film 1 provided covering the space 4, and a plurality of thermoelectric conversion elements 2 is arranged, adhered to the second surface 1b of the expansion film 1.

Moreover, each of the warm/cold expansion chambers 90 includes a supply source 14 that supplies a fluid, an actuator 5 as a drive unit that controls the inflow/outflow of the fluid in or out of the space 4 by its driving, and a pipe 15 connecting the space 4 to the supply source 14. Independently controlling each actuator 5 can individually control expansion of each of the warm/cold expansion chambers 90 and change the contact area of the finger tip with the presentation unit 9. In addition, controlling the thermoelectric conversion elements 2 of each of the warm/cold expansion chambers 90 independently of each other can achieve a wider variety of tactile presentation.

A configuration of the tactile presentation apparatus 32 will be described.

As shown in Fig. 6 (C), the tactile presentation apparatus 32 includes a support 3 and the presentation unit 9. The presentation unit 9 is constituted by a plurality of warm/cold expansion chambers 91.

Each of the warm/cold expansion chambers 91 includes a space 4 that allows a fluid to flow in or out of it, a second expansion film 12 provided covering the space 4, a first expansion film 11 arranged on an upper side than the second expansion film 12, and a plurality of thermoelectric conversion elements 2.

In the tactile presentation apparatus 32, the thermoelectric conversion elements 2 are arranged between the first expansion film 11 and the second expansion film 12 as in the second embodiment. One surface (skin side surface) is arranged, adhered to the second surface 11b of the first expansion film 11 and the other surface (non-skin side surface) is arranged, adhered to the first surface 12a of the second expansion film 12.

Moreover, the presentation unit 9 includes a supply source 14 that supplies a fluid, an actuator 5 as a drive unit that controls the inflow/outflow of the fluid in or out of the space 4 by its driving, and a pipe 15 connecting the space 4 to the supply source 14. Independently controlling each actuator 5 can individually control expansion of each of the warm/cold expansion chambers 90 can achieve a wider variety of tactile presentation.

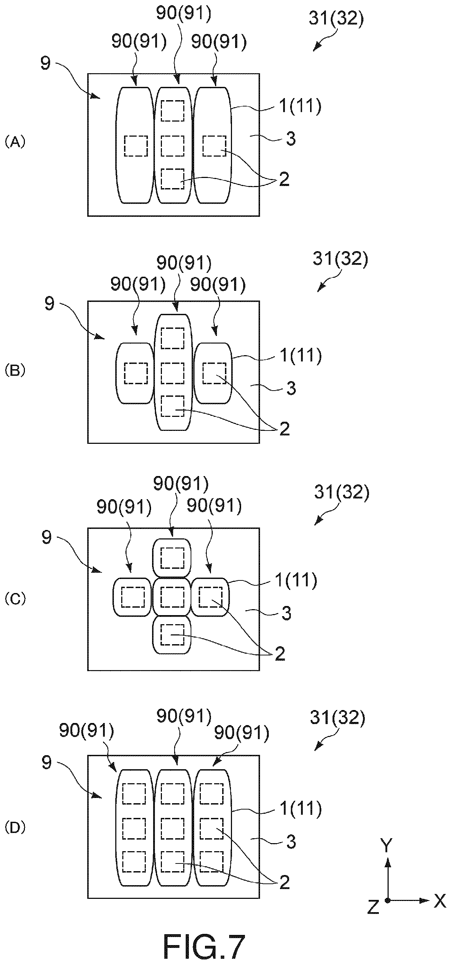

Fig. 7 (A) to (D) are plan views of the tactile presentation apparatus 31 (32) and are configuration examples of the presentation unit 9. It should be noted that the present technology is not limited to the forms shown in the figure, and various forms can be employed.

As shown in Fig. 7 (A), the presentation unit 9 may be constituted by three warm/cold expansion chambers 90 (91) arranged side by side in the X-axis direction. In the example shown in the figure, the expansion films 1 (first expansion films 11) that constitute the respective warm/cold expansion chambers 90 (91) have plane shapes that are substantially rectangular shapes. The plane shapes of the expansion films 1 (first expansion films 11) that constitute the respective warm/cold expansion chambers 90 (91) are substantially the same. The expansion films 1 (first expansion films 11) have a longitudinal direction parallel to the direction (Y-axis direction) in which the finger of the finger tip of the user U placed on the expansion films 1 (first expansion films 11) extends. Three thermoelectric conversion elements 2 separately arranged in the Y-axis direction are positioned in a warm/cold expansion chamber 90 (91) of the three warm/cold expansion chambers 90 (91), which is positioned at the center portion in the X-axis direction. A thermoelectric conversion element 2 of them, which is positioned at the center, is positioned at substantially the center of the expansion film 1 (first expansion film 11). In two warm/cold expansion chambers 90 (91) of the three warm/cold expansion chambers 90 (91), which are positioned on both sides, a single thermoelectric conversion element 2 is positioned at substantially the center of each of the expansion films 1 (first expansion films 11) that constitute such warm/cold expansion chambers 90 (91) in a planar view.

In the example shown in Fig. 7 (B), the presentation unit 9 is constituted by three warm/cold expansion chambers 90 (91) arranged side by side in the X-axis direction. In the example shown in the figure, the expansion films 1 (first expansion films 11) that constitute the respective warm/cold expansion chambers 90 (91) have substantially rectangular shapes. The warm/cold expansion chamber 90 positioned at the center portion in the X-axis direction is longer in the Y-axis direction than the warm/cold expansion chambers 90 (91) positioned on its both sides. In this manner, the expansion films 1 of the respective warm/cold expansion chambers 90 (91) have different sizes. Three thermoelectric conversion elements 2 separately arranged in the Y-axis direction are positioned in a warm/cold expansion chamber 90 (91) of the three warm/cold expansion chambers 90 (91), which is positioned at the center portion in the X-axis direction. A thermoelectric conversion element 2 of them, which is positioned at the center, is positioned at substantially the center of the expansion film 1 (first expansion film 11). In two warm/cold expansion chambers 90 (91) of the three warm/cold expansion chambers 90, which are positioned on both sides, a single thermoelectric conversion element 2 is positioned at substantially the center of each of the expansion films 1 (first expansion films 11) that constitute such warm/cold expansion chambers 90 (91) in a planar view.

In the example shown in Fig. 7 (C), the presentation unit 9 is constituted by five warm/cold expansion chambers 90 (91). In the example shown in the figure, the expansion films 1 (first expansion films 11) that constitute the respective warm/cold expansion chambers 90 (91) have plane shapes that are substantially square shapes. The plane shapes of the expansion films 1 (first expansion films 11) that constitute the respective warm/cold expansion chambers 90 (91) are substantially the same. A single thermoelectric conversion element 2 is arranged in each of the warm/cold expansion chambers 90 (91). The thermoelectric conversion element 2 is positioned at substantially the center of the expansion film 1 (first expansion film 11) in a planar view.

In the example shown in Fig. 7 (D), the presentation unit 9 is constituted by the three warm/cold expansion chambers 90 (91) arranged side by side in the X-axis direction. The expansion films 1 (first expansion films 11) that constitute the respective warm/cold expansion chambers 90 (91) have plane shapes that are substantially rectangular shapes. The plane shapes of the expansion films 1 (first expansion films 11) that constitute the respective warm/cold expansion chambers 90 (91) are substantially the same. Three thermoelectric conversion elements 2 separately arranged in the y-axis direction are positioned in each of the warm/cold expansion chambers 90 (91). A thermoelectric conversion element 2 of them, which is positioned at the center, is positioned at substantially the center of the expansion film 1 (first expansion film 11) in a planar view.

The tactile presentation apparatus 31 (32) has a configuration in which the plurality of thermoelectric conversion elements 2 is separately arranged on the plurality of entire expansion films 1 (entire first expansion films 11) in the presentation unit 9. The tactile presentation apparatus 31 (32) includes thermoelectric conversion element adhesion regions in which the expansion films 1 (first expansion films 11) are adhered to the thermoelectric conversion elements 2 and thermoelectric conversion element non-adhesion regions in which they are not adhered to each other. In addition, each of the warm/cold expansion chambers 90 (91) also includes the thermoelectric conversion element adhesion regions and the thermoelectric conversion element non-adhesion regions.

The presence of the thermoelectric conversion elements interferes with expansion of the expansion films 1 (first expansion films 11) in the thermoelectric conversion element adhesion regions. No thermoelectric conversion elements interfere with expansion of the expansion films 1 (first expansion films 11) in the thermoelectric conversion element non-adhesion regions.

In the presentation unit 9 of the tactile presentation apparatus 31 (32), the thermoelectric conversion element non-adhesion regions that do not interfere with expansion of the expansion films 1 (first expansion films 11) are distributed in the entire regions of the expansion films 1 (first expansion films 11). Accordingly, in a wide tactile presentation range, pressure stimulation by expansion of the expansion film can be applied and thermal stimulation with piezoelectric conversion elements can also be applied.

In addition, the thermoelectric conversion elements 2 are arranged on second surfaces 1b (11b) of the expansion films 1 (first expansion films 11), which are non-skin side surfaces. Therefore, during the use of the tactile presentation apparatus 31 (32), the finger tip of the user U indirectly touches the thermoelectric conversion elements 2 via the expansion films 1 (first expansion films 11). Accordingly, a hard and flat texture of the thermoelectric conversion elements 2 is not easily directly presented to the finger tip of the user. Thus, arranging the thermoelectric conversion elements 2 on the side of the first surface 11a does not deteriorate the presentation of a hard or soft texture by pressure stimulation. In this manner, arranging the thermoelectric conversion elements 2 on the second surfaces 1b (11b) of the expansion films 1 (first expansion films 11) achieves the structure in which the finger of the user U does not directly touch the thermoelectric conversion elements 2. A wider variety of tactile presentation can be thus achieved.

Moreover, the thermoelectric conversion elements 2 are arranged on the expansion films 1 (first expansion films 11) that are held in direct contact with the skin of the user during the use of the tactile presentation apparatus 31 (32). Therefore, thermal presentation by the thermoelectric conversion elements 2 to the skin of the user can be rapidly performed. That is, the use efficiency of heat dissipation and heat absorption by the thermoelectric conversion elements 2 can be made favorable, and thermal presentation to the user U can be achieved with small temperature increases or decreases in the thermoelectric conversion elements 2. Moreover, the power consumption can be reduced.

As described above, in the tactile presentation apparatus 31 (32), a variety of tactile presentation by pressure stimulation and thermal stimulation can be achieved and the power consumption can be reduced.

Fig. 2 (A) is a block diagram showing a configuration of the tactile presentation apparatus 31 (32). Fig. 2 (B) is a diagram for describing some configurations of the tactile presentation apparatus 30 in more detail and is a diagram showing a control configuration of the thermoelectric conversion element.

As shown in Fig. 2, the tactile presentation apparatus 31 (32) includes a control unit 6, the thermoelectric conversion elements 2 and the actuator 5 in the presentation unit 9, a communication unit 7, and a storage unit 8. The basic configuration is similar to the basic configuration of the first embodiment.

Next, an operation of the tactile presentation apparatus 31 during the use will be described with reference to Fig. 6 (A) and (B).

As shown in Fig. 6 (A), in a state in which the expansion film 1 has contracted after the inflow of the fluid, the abdomen of the finger tip of the user U is placed in contact with the three thermoelectric conversion elements 2C positioned at the center in the X-axis direction via the expansion film 1.

As shown in Fig. 6 (B), control can be made so that the fluid flows in and expands the spaces 4 of some of the warm/cold expansion chambers 90 and the fluid does not flow in the spaces 4 of the other warm/cold expansion chambers 90. In the example shown in the figure, the fluid is prevented from flowing in the warm/cold expansion chamber 90 positioned at the center portion in the X-axis direction and the fluid is allowed to flow in only the warm/cold expansion chambers 90 on both the left- and right-hand sides. Accordingly, the presentation unit 9 is generally deformed so as to cover a part of the finger tip along the shape of the finger tip of the user U. As a result, the abdomen and the lateral portions of the finger of the user U are held in contact with the three thermoelectric conversion elements 2C positioned at the center portion in the X-axis direction and the two thermoelectric conversion elements 2S positioned at the side portions in the X-axis direction via the expansion film 1. The thermoelectric conversion elements 2 are adhered and fixed to the expansion film 1. Therefore, during expansion of the expansion film 1, the positions of the thermoelectric conversion elements 2 change with deformation of the expansion film 1. Therefore, the thermoelectric conversion elements 2 are held in contact with the finger tip via the expansion film 1. Therefore, the thermoelectric conversion elements 2 have favorable heat use efficiency, and the thermal presentation can be effectively performed.

Also in the tactile presentation apparatus 32 shown in Fig. 6 (C), selecting one of the warm/cold expansion chambers 91 in which the fluid is allowed to flow can change the shape of the first expansion film 11 in the entire presentation unit 9 as in the tactile presentation apparatus 31.

As described above, the tactile presentation apparatus can be configured to include the plurality of warm/cold expansion chambers. Accordingly, thermal stimulation can be changed using the thermoelectric conversion elements while changing a pressure sensation or stiffness sensation more freely.

### <Fourth Embodiment>

In the above-mentioned first to third embodiments, each tactile presentation apparatus may include one or more sensors selected from a thermal sensor, a distance sensor, and an air pressure sensor.

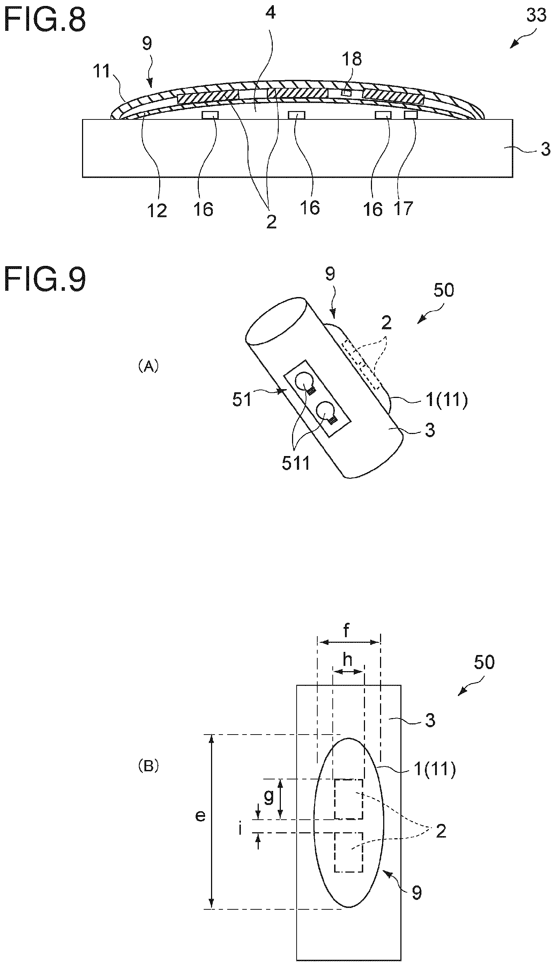

Fig. 8 shows an example of a tactile presentation apparatus 33 including a sensor(s). In Fig. 8, an example in which two expansion films are provided as in the second embodiment will be described. However, it can also be applied in the tactile presentation apparatuses according to the first and third embodiments.

As shown in Fig. 8, a thermal sensor 18 may be arranged in a first expansion film 11. In the example shown in the figure, the thermal sensor 18 is arranged on a second surface 11b of the first expansion film 11. The thermal sensor 18 measures a temperature of the first expansion film 11. Moreover, the thermal sensor 18 can be used for estimating a temperature of the finger tip of the user U that is held in contact with the first expansion film 11. For example, a difference between a value actually measured by the thermal sensor 18 and an actual temperature of the finger tip when the finger tip is placed on the thermal sensor 18 via the first expansion film 11 can be measured in advance and a temperature of the finger tip can be estimated based on the value actually measured by the thermal sensor 18.

The measurement result of the thermal sensor 18 is used for controlling the temperature of the first expansion film 11 or the like.

The use of the thermal sensor 18 can control a temperature range of the first expansion film 11 affected by heat dissipation and heat absorption of the thermoelectric conversion elements 2 to be in a desired range. For example, settings can be made so that the thermoelectric conversion elements are not heated above 40°C for preventing burns or the thermoelectric conversion elements are not too cold below 20°C. The thermal sensor 18 can be used as a limiter as such, and the safety during the use can be enhanced.

It should be noted that as to the tactile presentation apparatus including the single expansion film, the thermal sensor 18 is arranged on the expansion film 1. Alternatively, the thermal sensor 18 may be provided in the thermoelectric conversion element.

As shown in Fig. 8, a distance sensor 16 may be arranged on the support 3. The distance sensor 16 is capable of measuring a distance to the second expansion film 12. The first expansion film 11 is deformed with deformation of the second expansion film 12. Therefore, the distance to the first expansion film 11 can also be estimated based on a measurement result of the distance sensor 16. In the example shown in the figure, a plurality of distance sensors 16 is provided. The plurality of distance sensors 16 provided can obtain distribution information of distances of the first and second expansion films from the support 3 in a planar view.

The measurement results of the distance sensors 16 are used for controlling the force of pressure stimulation.

Moreover, the use of the distance sensors 16 can control the degree of expansion to be in a desired range so as to prevent the second expansion film 12 and thus the first expansion film 11 from expanding excessively and bursting when the fluid flows in it. In this manner, the distance sensor 16 can be used as a limiter, and the safety during the use can be enhanced.

As shown in Fig. 8, an air pressure sensor 17 may be arranged on the support 3. The air pressure sensor 17 measures a pressure in the space 4.

The measurement result of the air pressure sensor 17 is used for controlling the force of pressure stimulation.

Moreover, the use of the air pressure sensor 17 can control the degree of expansion to be in a desired range so as to prevent the second expansion film 12 and thus the first expansion film 11 from expanding excessively and bursting when the fluid flows in it. In this manner, the air pressure sensor 17 can be used as a limiter, and the safety during the use can be enhanced.

Moreover, for example, in a case of using the tactile presentation apparatus held in the hand as in a first application example to be described later, the air pressure sensor 17 may be capable of detecting a change in pressure when grabbing it and may feed back the detection result for thermal stimulation as well as pressure stimulation.

### <Application Examples>

The tactile presentation apparatus according to the present technology can be used for various applications. The use of the tactile presentation apparatus for a virtual reality (VR) or augmented reality (AR) apparatus, for example, can present to the user a tactile sense as if a virtual object actually touched the user.

The tactile presentation apparatus can be used typically for any application, e.g., a wearable apparatus, an input apparatus, a medical apparatus, a simulation apparatus, or an entertainment apparatus, as long as it presents a tactile sense to the user.

Moreover, the shape of the tactile presentation apparatus can be set as appropriate depending on an application. In each of the above-mentioned embodiments, the example in which the tactile presentation target site is the finger tip and the tactile presentation apparatus has such a shape that the presentation unit is provided on the flat support. However, the support can have various shapes depending on a tactile presentation target site and an application.

Hereinafter, specific application examples and form examples of the tactile presentation apparatus will be described, though the present technology is not limited to those described here.

### [First Application Example]

A first application example will be described with reference to Figs. 9 to 11.

Fig. 9 (A) is a perspective view of a tactile presentation apparatus 50. Fig. 9 (B) is a plan view of the tactile presentation apparatus 50 as viewed from the side on which the presentation unit 9 is arranged.

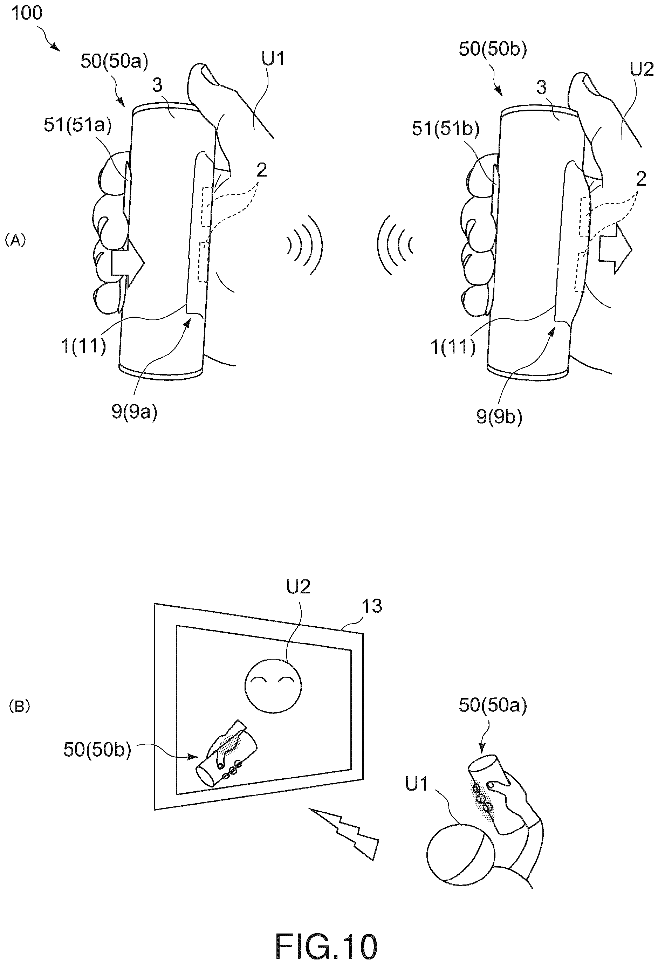

Fig. 10 is a diagram showing a tactile presentation system 100 using the tactile presentation apparatus 50.

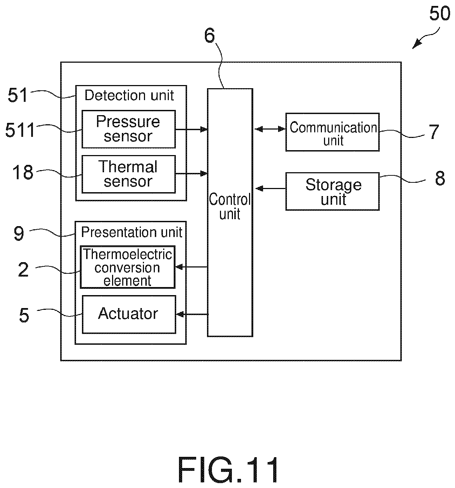

Fig. 11 is a block diagram showing an internal configuration of the tactile presentation apparatus 50.

Here, a plurality of users located remotely from each other uses their tactile presentation apparatuses 50 for performing tactile communication with each other as an example.

As shown in Fig. 9 (A), the tactile presentation apparatus 50 includes a support 3 that is a casing, a detection unit 51 provided on the support 3, and a presentation unit 9 provided on the support 3.

The support 3 has such a size that the user U can hold it in one hand. In the present embodiment, the support 3 has a cylindrical shape with both ends closed. It should be noted that the shape of the support 3 is not limited thereto. For example, the support 3 may be configured in a polygonal tube shape such as a triangular tube shape and a rectangular tube shape or may be configured in a shape that mimics a human hand, for example.

The detection unit 51 includes a pressure sensor 511 that detects a force from the user U and a thermal sensor 18 that detects a temperature of hand skin of the user U. The detection unit 51 includes two pressure sensors 511 in the present embodiment. However, the number of pressure sensors 511 is not limited thereto.

The detection unit 51 is provided at a position corresponding to the fingers of the user when the user grabs the tactile presentation apparatus 50. In the present embodiment, the detection unit 51 is provided at a position corresponding to DIP joints of four fingers that are an index finger, a middle finger, a ring finger, and a little finger.

It should be noted that the position where the detection unit 51 is provided is not limited thereto. For example, the detection unit 51 may be provided at a position corresponding to one, two, three, four, or five fingers selected from fingers that are a thumb, an index finger, a middle finger, a ring finger, and a little finger. Moreover, the detection unit 51 may be provided at a position corresponding to PIP joints or MCP joints (excluding the thumb) of the fingers.

Alternatively, detection units 51 may be separately provided at two or more separated positions. For example, the first detection unit 51 may be arranged at a position corresponding to the index finger, the middle finger, the ring finger, and the little finger and the second detection unit 51 may be arranged at a position corresponding to the thumb. Alternatively, for example, the first detection unit 51 may be arranged at a position corresponding to the DIP joints of the index finger, the middle finger, the ring finger, and the little finger and the second detection unit 51 may be arranged at a position corresponding to the PIP joints or MCP joints of the index finger, the middle finger, the ring finger, and the little finger, for example.

Typically, the detection unit 51 may be provided at any position or a plurality of detection units 51 may be provided at separated positions on the single tactile presentation apparatus as long as the detection unit(s) 51 can suitably detect a grabbing force by the user and the detection unit(s) 51 are provided at position(s) different from the position(s) of the presentation unit(s) 9.

The presentation unit 9 presents a tactile sense to the user U. The presentation unit 9 is provided at a position on the support 3, which is different from the position(s) of the detection unit(s) 51.

The presentation unit described in each of the above-mentioned embodiments can be applied as the presentation unit 9. Here, a single expansion film is provided as in the presentation unit described in the first embodiment as an example.

The presentation unit 9 includes a space 4 that allows a fluid to flow in or out of it, an expansion film 1 provided covering the space 4, and a plurality of thermoelectric conversion elements 2 arranged on a second surface 1b of the expansion film 1. Moreover, the presentation unit 9 includes a supply source 14 that supplies a fluid, an actuator 5 as a drive unit that controls the inflow/outflow of the fluid in or out of the space 4 by its driving, and a pipe 15 connecting the space 4 to the supply source 14.

In the present embodiment, the presentation unit 9 includes two thermoelectric conversion elements 2. The two thermoelectric conversion elements 2 are arranged, spaced apart from each other. Moreover, the expansion film 1 has an ellipse shape whose longitudinal direction is parallel to a longitudinal direction of the support 3 in a planar view.

The presentation unit 9 applies pressure stimulation and thermal stimulation and presents a variety of tactile senses to the hand of the user U holding the tactile presentation apparatus 50.

Moreover, the presentation unit 9 expands and contracts the expansion film 1 with the fluid in accordance with a force and a skin temperature of the hand detected by the detection unit 51 of the other tactile presentation apparatus 50 as will be described later and performs thermal presentation using the thermoelectric conversion elements 2. In this manner, the presentation unit 9 presents a tactile sense to the user.

Here, providing the detection unit 51 and the presentation unit 9 at the same position causes a problem in that it is difficult for the user to recognize whether a force that the user is feeling is a reaction force to grabbing the tactile presentation apparatus 50 by the user himself/herself or a grabbing force from a counterpart user. Therefore, in the present embodiment, the detection unit 51 and the presentation unit 9 are provided at different positions.

In the present embodiment, the presentation unit 9 is provided at a position corresponding to the palm (center of the palm) when the user grabs the tactile presentation apparatus 50. It should be noted that the position where the presentation unit 9 is provided is not limited thereto. For example, the presentation unit 9 may be provided at a position corresponding to the fingers of the user. In this case, the detection unit 51 may be provided at a position other than the fingers, such as the palm.

Moreover, the presentation unit 9 may be separately provided at two or more separated positions. For example, the first presentation unit 9 may be arranged at a position of the palm that is closer to the index finger and the second presentation unit 9 may be arranged at a position of the palm that is closer to the little finger.

Typically, the presentation unit 9 may be provided at any position or a plurality of presentation units 9 may be provided at separated positions on the single tactile presentation apparatus 50 as long as the presentation unit(s) 9 can suitably present a tactile sense caused by a force of one user to the other user and the presentation unit(s) 9 are provided at position(s) different from the position(s) of the detection unit(s) 51.

It should be noted that the positions of the presentation unit 9 and the detection unit 51 may be set in consideration of a hand position where a human feels a force when two people actually shake hands. For example, when two people actually shake hands, one person feels a force from the index finger, the middle finger, the ring finger, the little finger, and the like of the other person at a region of the palm on the little finger side. Thus, in a case where the detection unit 51 is provided at a position corresponding to the index finger, the middle finger, the ring finger, the little finger, and the like, the presentation unit 9 may be provided at the region of the palm on the little finger side.

As shown in Fig. 11, the tactile presentation apparatus 50 includes a control unit 6, the pressure sensor 511 and the thermal sensor 18 in the detection unit 51, the thermoelectric conversion elements 2 and the actuator 5 in the presentation unit 9, a communication unit 7, and a storage unit 8.

The control unit 6 executes various programs stored in the storage unit 8 on the basis of various arithmetic operations and comprehensively controls the respective units of the tactile presentation apparatus 50.

The pressure sensor 511 is a part of the detection unit 51. The pressure sensor 511 is provided at a position corresponding to the detection unit 51 on the side of the surface of the support 3. The pressure sensor 511 detects a force (grabbing force) of the user and outputs a detection value to the control unit 6.

The thermal sensor 18 is a part of the detection unit 51. The thermal sensor 18 is provided on the expansion film 1 of the presentation unit 9 with which the hand skin of the user U is to be held in direct contact, for example, when grabbing the tactile presentation apparatus 50. The thermal sensor 18 detects a temperature of the hand skin of the user U and outputs the detected temperature to the control unit 6.

The storage unit 8 includes various programs required for the processing of the control unit 6, a nonvolatile memory for storing various types of data, and a volatile memory used as a working area for the control unit 6.

The communication unit 7 is configured to be capable of mutually communicating with the other tactile presentation apparatus 50 in a wired or wireless manner. It should be noted that the tactile presentation apparatus 50 may directly communicate with the other tactile presentation apparatus 50 or may indirectly communicate with the other tactile presentation apparatus 50 via another apparatus such as a server apparatus in a network.

### [Operation Description]

Here, a plurality of users located remotely from each other uses their tactile presentation apparatuses 50 for performing tactile communication with each other as an example.

Fig. 10 (A) is a view describing the tactile presentation system 100 capable of performing tactile communication with each other even in a case where two users are located remotely from each other.

Fig. 10 (B) shows a state in which the two users perform tactile communication using the tactile presentation apparatus 50.

Here, in order to clearly distinguish the two tactile presentation apparatuses 50, one tactile presentation apparatus 50 will be referred to as a first tactile presentation apparatus 50a and the other tactile presentation apparatus 50 will be referred to as a second tactile presentation apparatus 50b. Moreover, in order to distinguish the two users, a user who operates the first tactile presentation apparatus 50a will be referred to as a first user U1 and a user who operates the second tactile presentation apparatus 50b will be referred to as a second user U2.

Moreover, as to the first tactile presentation apparatus 50a and the second tactile presentation apparatus 50b, the terms "first..." and "second..." are used for distinguishing the portions and the like that constitute similar configurations.

As shown in Fig. 10 (B), the first user U1 and the second user U2 are able to perform tactile communication by using the first tactile presentation apparatus 50a and the second tactile presentation apparatus 50b that they hold while looking at a display 13 showing the counterpart.

It should be noted that although a case where the number of tactile presentation apparatuses 50 is two will be described here, the number of tactile presentation apparatuses 50 may be three or more. Similarly, the number of users is not limited to two, and may be three or more. Moreover, some of the users may include a virtual person (e.g., a cartoon character or virtual idol displayed on the screen).

### (Case Where First User U1 Grabs First Tactile Presentation Apparatus 50a)

As shown in Fig. 10 (A) and (B), when the first user U1 holds the first tactile presentation apparatus 50a and grabs the first tactile presentation apparatus 50a, a pressure sensor 511 in a first detection unit 51a detects a first pressure value depending on a grabbing force of the first user U1. In addition, a thermal sensor 18 in the first detection unit 51a detects a first temperature value of the hand skin of the first user U1. A first control unit 6 sends the detected first pressure value and first temperature value to the second tactile presentation apparatus 50b directly or indirectly via a server apparatus, for example.

The detected first pressure value and first temperature value are the tactile presentation-related information.

A second control unit 6 of the second tactile presentation apparatus 50b receives the first pressure value and the first temperature value from the first tactile presentation apparatus 50a directly or indirectly via a server apparatus, for example.

The second control unit 6 drives an actuator 5 of a second presentation unit 9b in accordance with the first pressure value and controls the inflow/outflow of a fluid in or out of a second space 4. Accordingly, the second control unit 6 presents a pressure sensation according to the first pressure value to the second user U2 by expanding and contracting the expansion film 1 of the second presentation unit 9b. Accordingly, the second tactile presentation apparatus 50b can present to the second user U2 a sensation of pushing the palm by expansion of the expansion film and present to the second user U2 a sensation of restoring the pushed palm to the original state by contraction of the expansion film.

In addition, the second control unit 6 controls thermoelectric conversion elements 2 of the second presentation unit 9b to be heated or cooled so that the expansion film 1 of the second presentation unit 9b takes the first temperature value, thereby presenting a temperature sensation according to the first temperature value to the second user U2.

Accordingly, the second tactile presentation apparatus 50b can present to the second user U2 a sense of touch as if the hand was grabbed by the first user U1.

### (Case Where Second User U2 Grabs Second Tactile Presentation Apparatus 50b)

When the second user U2 holds the second tactile presentation apparatus 50b and grabs the second tactile presentation apparatus 50b, a pressure sensor 511 in a second detection unit 51b detects a second pressure value depending on a grabbing force of the second user U2. In addition, a thermal sensor 18 in the second detection unit 51b detects a second temperature value of the hand skin of the second user U2. The second control unit 6 sends the detected second pressure value and second temperature value to the first tactile presentation apparatus 50a directly or indirectly via a server apparatus, for example.

The detected second pressure value and second temperature value are tactile presentation-related information.

A first control unit 6 of the first tactile presentation apparatus 50a receives the second pressure value and the second temperature value from the second tactile presentation apparatus 50b directly or indirectly via a server apparatus, for example.

The first control unit 6 drives an actuator 5 of a first presentation unit 9a in accordance with the second pressure value and controls the inflow/outflow of a fluid in or out of a first space 4. Accordingly, the first control unit 6 presents a pressure sensation according to the second pressure value to the first user U1 by expanding and contracting the expansion film 1 of the first presentation unit 9a. The first tactile presentation apparatus 50a can present to the first user U1 a sensation of pushing the palm by expansion of the expansion film and present to the first user U1 a sensation of restoring the pushed palm to the original state by contraction of the expansion film.

In addition, the first control unit 6 controls thermoelectric conversion elements 2 of the first presentation unit 9a to be heated or cooled so that the expansion film 1 of the first presentation unit 9a takes the second temperature value, thereby presenting a temperature sensation according to the second temperature value to the first user U1.

Accordingly, the first tactile presentation apparatus 50a can present to the first user U1 a sense of touch as if the hand was grabbed by the second user U2.

In this manner, the temperature presentation reflecting the detected temperature value as it is is performed to the second user U2 (first user U1) in accordance with the temperature value detected by the thermal sensor 18 of the first tactile presentation apparatus 50a (second tactile presentation apparatus 50b) held by the first user U1 (second user U2).

### [Second Application Example]

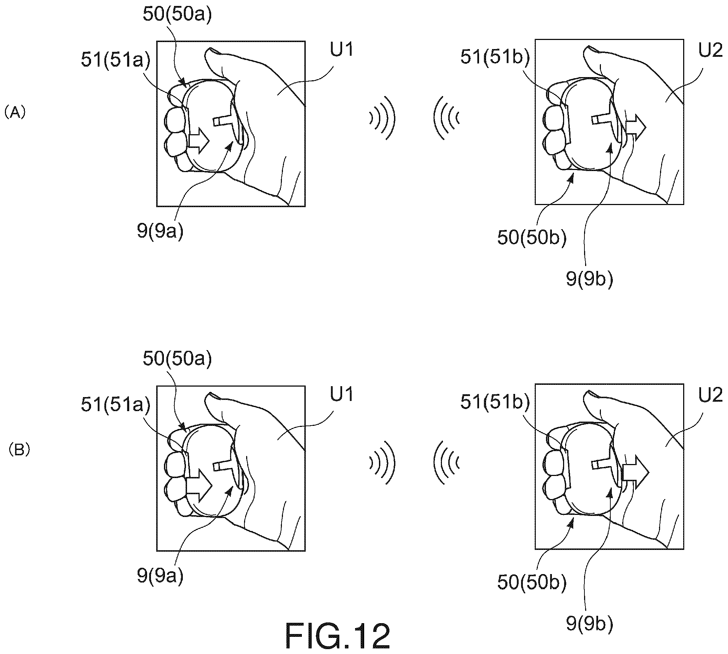

A second application example will be described with reference to Fig. 12.

In the above-mentioned first application example, the example in which the temperature presentation reflecting their hand temperatures to the two users is performed has been described. In this application example, the temperature presentation reflecting their grabbing forces is performed irrespective of the hand temperatures as an example. Moreover, in this application example, the entire shape of the tactile presentation apparatus is different from that of the first application example and the tactile presentation apparatus has a size that can be held by the palm as an example. However, the basic configuration is similar to the basic configuration of the first application example.

Fig. 12 (A) and (B) are schematic views showing an example in which a force of the first user U1 when grabbing the first tactile presentation apparatus 50a is reflected and presented as a temperature rise at the second tactile presentation apparatus 50b.

Fig. 12 (A) shows a case where the force when the user grabs the tactile presentation apparatus is relatively small. Fig. 12 (B) shows a case where the force when the user grabs the tactile presentation apparatus is larger than that of Fig. 12 (A).

In the first tactile presentation apparatus 50a in Fig. 12, the arrow schematically shows a force applied on the first tactile presentation apparatus 50a when the user grabs the tactile presentation apparatus and its size represents the magnitude of the force when the user grabs the tactile presentation apparatus.

In the second tactile presentation apparatus 50b in Fig. 12, the arrow shows a direction of expansion of the expansion film and its size represents the magnitude of the temperature rise of the thermoelectric conversion elements 2 of the second presentation unit 9b.

Hereinafter, the temperature presentation reflecting their grabbing forces will be mainly described. It should be noted that a pressure sensation by expansion of the expansion film reflecting their grabbing forces is also simultaneously presented.

In this application example, one tactile presentation apparatus detects a pressure value and the other tactile presentation apparatus performs thermal presentation in accordance with the detected pressure value. It should be noted that numeric values exemplified here are merely exemplary and the present technology is not limited thereto.

In the example shown in Fig. 12 (A), in a case where the first user U1 grabs the first tactile presentation apparatus 50a with a pressure value A, the thermoelectric conversion elements 2 in the second tactile presentation apparatus 50b are controlled so that the temperature of the expansion film 1 increases by 1°C. For example, the thermoelectric conversion elements 2 in the second tactile presentation apparatus 50b are controlled so that the temperature of the expansion film 1 changes from 34°C to 35°C.

In the example shown in Fig. 12 (B), in a case where the first user U1 further grabs the first tactile presentation apparatus 50a with a pressure value B larger than the pressure value A, the thermoelectric conversion elements 2 in the second tactile presentation apparatus 50b are controlled so that the temperature of the expansion film 1 increases by 2°C. For example, the thermoelectric conversion elements 2 in the second tactile presentation apparatus 50b are controlled so that the temperature of the expansion film changes from 35°C to 37°C.

As to the rise of the presented temperature, the temperature is controlled not to exceed 40°C in view of the safety.

As described above, the thermoelectric conversion elements 2 of the second presentation unit 9b may be controlled to raise the presented temperature in the second tactile presentation apparatus 50b as a receiver as the pressure increases by the first user U1 as a sender more strongly grabbing the first tactile presentation apparatus 50a, in other words, as the detected pressure value increases.

Accordingly, with an increase in pressure value by an increase in grabbing force of the first user U1 as the sender, increased pressure stimulation and increased heating stimulation by the thermoelectric conversion elements 2 of the second presentation unit 9b are presented to the second user U2 as the receiver. The second user U2 can feel intensified grabbing force of the first user U1.

Moreover, a desired temperature can be rapidly presented by performing thermal presentation using the thermoelectric conversion elements (Peltier devices). Accordingly, an operation change, for example, when the user as the sender increases or reduces the force grabbing the tactile presentation apparatus can be rapidly presented as a temperature change at the tactile presentation apparatus as the receiver.

It should be noted that sensitivity to pressure sensation presentation or warm/cold sensation presentation differs depending on individual differences in age, gender, skin stiffness, and the like of the user U. Therefore, personal information such as age and gender may be set as initial settings during the use, for example, and the pressure level and the degree of warmness/coldness may be finely adjusted in accordance with the age and gender.

In the first and second application examples, for example, a grandson/granddaughter can communicate with his or her grandfather/mother located remotely by using the tactile presentation apparatus 50.

In addition, a performer such as a singer grabs the tactile presentation apparatus 50 at a concert venue so that the tactile presentation apparatuses 50 held by a plurality of audience members can present a sensation of being grabbed to the audience members, respectively. Moreover, at a handshake event with a celebrity, the users can shake hands with the celebrity by using the tactile presentation apparatuses 50 even from remote locations. In this manner, a tactile sense can also be simultaneously presented to a plurality of people by using the tactile presentation apparatus 50 held by a person in charge on the basis of a detection result detected by one tactile presentation apparatus 50.

### [Third Application Example]

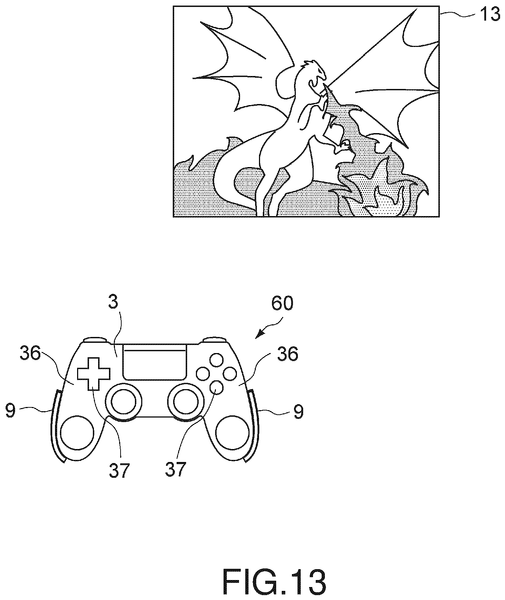

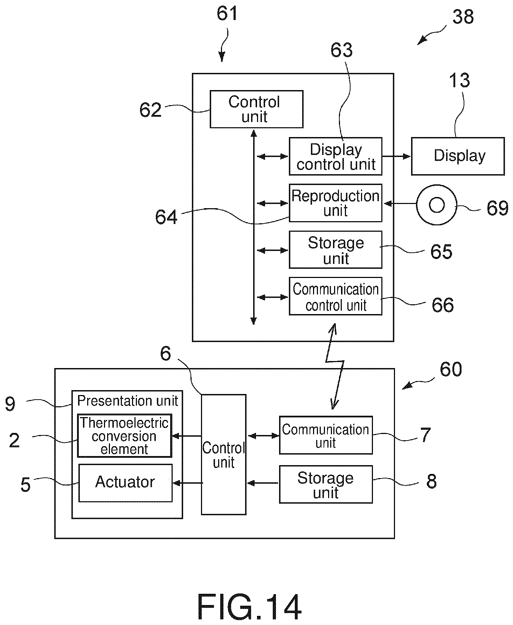

A third application example will be described with reference to Figs. 13 and 14. Here, tactile presentation associated with a game video is performed as an example.

Fig. 13 shows a state when the tactile presentation apparatus is used.

Fig. 14 is a block diagram showing an internal configuration of a game console main body and a tactile presentation apparatus.

As shown in Fig. 13, the user U is able to hold a tactile presentation apparatus 60 that is a game controller and play the game while looking at the display 13 such as a television set. The tactile presentation apparatus 60 presents to the user U a tactile sense associated with a game video displayed on the display 13.

The tactile presentation apparatus 60 includes a support 3 that is a game controller main body and presentation units 9 provided on the support 3. The tactile presentation apparatus 60 according to the present embodiment also functions as an input apparatus that receives input operations of the game besides the tactile presentation function.

The support 3 is a mold product made of a resin material, e.g., plastics. The support 3 includes projecting grip portions 36 held by the hands of the user U on both left- and right-hand sides. The support 3 includes an operation unit including various key pads 37 for receiving operations made by the user U.

The presentation units 9 present a tactile sense to the user U. The presentation units 9 are respectively provided in the left and right grip portions 36.

The presentation unit described in each of the above-mentioned embodiments can be applied as each of the presentation units 9.

As shown in Fig. 14, a game apparatus 38 includes a game console main body 61 to which a tactile presentation apparatus 60 that is one or more game controllers is connected. The game console main body 61 is connected to a display 13 such as a television set.

The game console main body 61 includes a control unit 62, a display control unit 63, a reproduction unit 64, a storage unit 65, and a communication control unit 66.

The communication control unit 66 is a communication means to which the tactile presentation apparatus 60 is connected.

The reproduction unit 64 reproduces a program of a game recorded on a recording medium 69 such as an optical disc. The program may include tactile presentation-related information according to a video associated with the video of the game.

The display control unit 63 controls the display 13.

The storage unit 65 is constituted by a read only memory (ROM) and the like. The storage unit 65 stores an operating system (OS) and the like executed in the control unit 62.

The control unit 62 is constituted by a central processing unit (CPU), a random access memory (RAM), and the like. The control unit 62 makes the game progress on the basis of an operation signal according to the operation contents received in accordance with an operation made by the user U on the tactile presentation apparatus 60 and the program of the game reproduced from the recording medium 69. The control unit 62 displays an image on the display 13 in accordance with the progress of the game and, at the same time, outputs tactile presentation-related information for controlling each of the actuator 5 and the thermoelectric conversion elements 2 of the tactile presentation apparatus 60 for presenting a tactile sense associated with the contents of the game video to the user U. The tactile presentation-related information may be prepared in advance, associated with the game video as described above. Alternatively, the control unit 6 of the tactile presentation apparatus 60 may generate the tactile presentation-related information according to the video on the basis of the contents of the game video by using tactile presentation-related information generated as a database. For example, tactile presentation-related information associated with each video content such as an explosion scene is stored as the database. The tactile presentation-related information includes thermal stimulation-related information including control patterns (control signals) of the thermoelectric conversion elements and pressure stimulation-related information (control signal) including control patterns of the actuator.

The tactile presentation apparatus 60 includes a control unit 6, the thermoelectric conversion elements 2 and the actuator 5 in the presentation unit 9, a communication unit 7, and a storage unit 8.

The control unit 6 controls the actuator 5 and the thermoelectric conversion element 2 on the basis of a control signal output from the game console main body 61.

For example, in the example shown in Fig. 13, the display 13 shows a video in which a dragon breathes fire. The thermoelectric conversion elements 2 are controlled to increase in temperature. Accordingly, heat of the fire can be presented to the user U. Moreover, the actuator 5 is controlled so that the fluid flows in the space 4. The impact of hot wind is presented to the user U with a pressure of expansion of the expansion film 1 (or the first expansion film 11 and the second expansion film 12) by the inflow of the fluid.

In this manner, providing the game controller with the presentation unit 9 that applies pressure stimulation and thermal stimulation enables a tactile sense associated with the game video to be presented to the user. Thus, the sense of presence can be further increased.

Here, the television set has been described as an example of the apparatus that presents the video to the user U. However, a head-mounted display, a monitor projector, or the like may be employed.

### [Fourth Application Example]

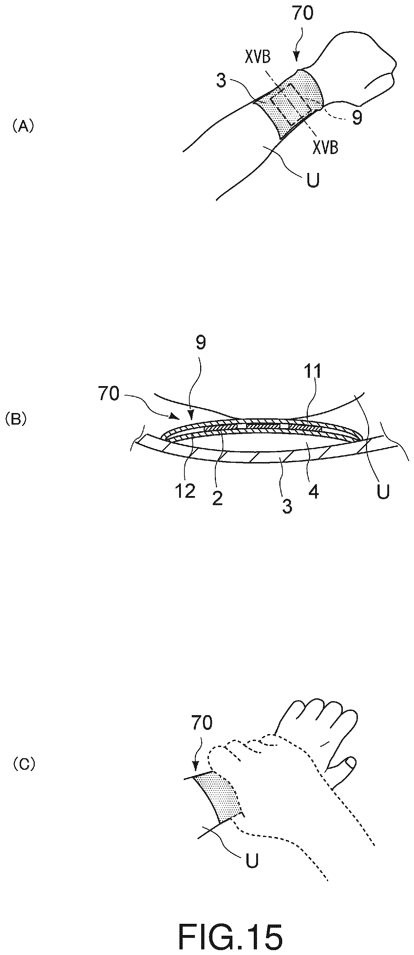

A fourth application example will be described with reference to Fig. 15.

Fig. 15 (A) shows a state in which the user U uses a tactile presentation apparatus 70.

Fig. 15 (B) is a cross-sectional view of a portion taken along the line XVB-XVB in Fig. 15 (A).

Fig. 15 (C) is a diagram for describing a tactile presentation example. In the figure, the broken line represents a virtual person.

As shown in Fig. 15 (A), the tactile presentation apparatus 70 includes a support 3 and a presentation unit 9 provided on the support 3. The support 3 has a wristband shape wrapped around the wrist of the user U and is configured to be flexibly deformable.

As shown in Fig. 15 (B), the presentation unit 9 is arranged to be held in contact with the inside of the wristband shaped support 3, i.e., the skin of the user U during the use. The presentation unit 9 may be arranged in the entire periphery of the wrist or may be arranged in a part of the periphery of the wrist and can be set as appropriate depending on an application. Moreover, one or more presentation units 9 can be arranged.

The presentation unit 9 presents a tactile sense to the user U. In Fig. 15 (B), two expansion films are provided as an example. The presentation unit described in each of the above-mentioned embodiments can be applied to the presentation unit 9. During the use, the first expansion film 11 and the second expansion film 12 expand toward the skin of the user U and present a pressure sensation to the user U by a fluid flowing in the space 4.

A specific application example will be described.

For example, a head-mounted display capable of VR display, AR display, or the like is put on the head of the user U and the tactile presentation apparatus 70 is attached to the wrist.

The head-mounted display presents a video of a virtual space to the user U. In a case where the wrist is grabbed by a virtual person in the virtual space, the actuator 5 and the thermoelectric conversion element 2 are respectively controlled to present a sensation of being grabbed at the wrist to the user U as shown in Fig. 15 (C).

The thermoelectric conversion elements 2 are controlled to increase in temperature, for example. Accordingly, the warmness of the hand of the virtual person is presented to the user U.

Moreover, the actuator 5 is controlled so that the fluid flows in the space 4. A pressure sensation when the virtual person grabs the wrist of the user U is expressed to the user U with a pressure by expansion of the first expansion film 11 and the second expansion film 12 by the inflow of the fluid. At this time, an amount of fluid flowing in the space 4 may be controlled in accordance with a force of grabbing the wrist of the virtual person or the pressure level by the expansion film may be controlled.

The actuator 5 and the thermoelectric conversion element 2 are controlled on the basis of a tactile presentation control signal that is tactile presentation-related information associated with the video information, for example, as in the third application example. Accordingly, a tactile sense associated with a video can be presented to the user U and the sense of presence can be enhanced.

### [Fifth Application Example]

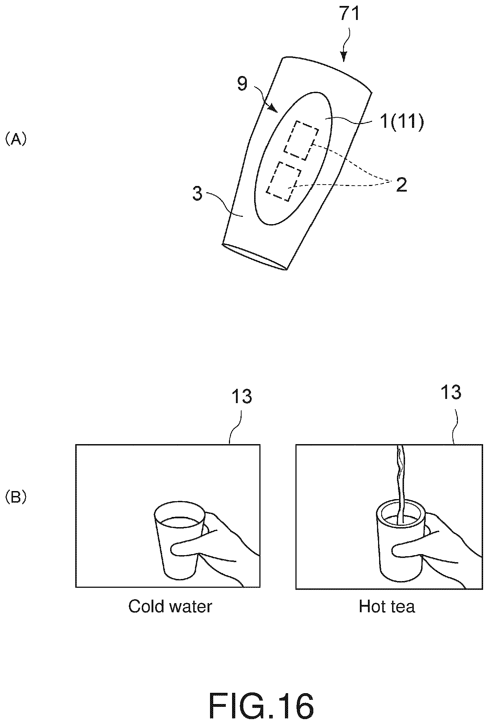

The tactile presentation apparatus can take a form shown in Fig. 16 (A).

Fig. 16 (A) is a perspective view of a tactile presentation apparatus 71.

Fig. 16 (B) is a diagram for describing a tactile presentation example using the tactile presentation apparatus 71.

As shown in Fig. 16 (A), the tactile presentation apparatus 71 includes a support 3 and a presentation unit 9 provided on the support 3. The support 3 has such a size that the user U can hold it in one hand. In the present embodiment, the support 3 has a substantially cylindrical shape, has a shape whose diameter gradually becomes smaller toward one end from the center in the longitudinal direction, and a shape that mimics a glass shape whose diameter becomes smaller toward the bottom from the opening.

As shown in Fig. 16 (B), in a case where the display 13 shows an image in which someone holds a glass containing cold water in his/her hand, the thermoelectric conversion elements 2 are controlled to lower in temperature. Accordingly, the coldness of the cold water glass is presented to the user U.

As shown in Fig. 16 (B), in a case where the display 13 shows an image in which someone is pouring hot tea in a teacup held in the hand, the thermoelectric conversion elements 2 are controlled to gradually increase in temperature, for example. Accordingly, a sensation of gradually pouring hot tea in the teacup and the warmness of the tea are presented to the user U.

### [Sixth Application Example]

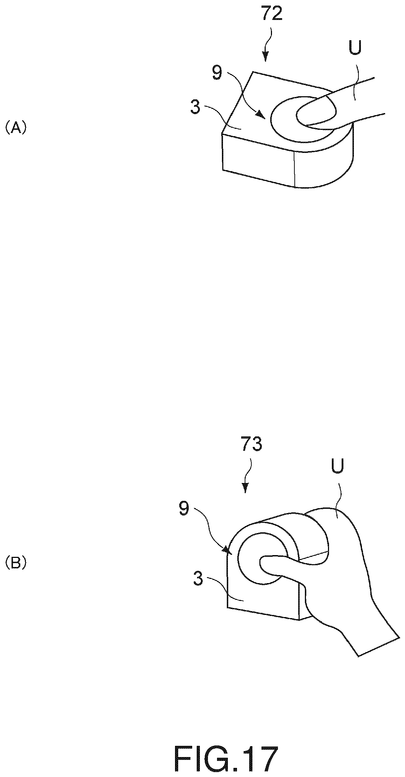

The tactile presentation apparatus can take a form shown in, for example, Fig. 17 (A) and (B).

Fig. 17 (A) and (B) are perspective views of tactile presentation apparatuses 72 and 73.

As shown in Fig. 17 (A) and (B), each of the tactile presentation apparatuses 72 and 73 includes a support 3 and a presentation unit 9 provided on the support 3. In either tactile presentation apparatus, the finger of the user U is held in contact with the presentation unit 9 during the use. In each of the tactile presentation apparatuses 72 and 73, the presentation unit 9 is capable of presenting a pressure sensation, a stiffness sensation such as hardness and softness, a thermal sensation such as warmness and coldness to the user U. The presentation unit 9 is capable of presenting, for example, a stiffness sensation and a thermal sensation of the virtual object in the video to the user U.

### <Configuration Example Associated with Presentation Unit>

Hereinafter, a configuration associated with the presentation unit 9 will be described.

The dimensions, number, and arrangement of the thermoelectric conversion elements can be set as appropriate depending on an application of the tactile presentation apparatus and a tactile presentation target site. Although the description will be given using numeric values hereinafter, they are merely exemplary and the present technology is not limited thereto.

### [Thermal Conductivity of Expansion Film]

The thermal conductivity of the expansion film 1 and the first expansion film 11 is favorably 0.2 W/mK or more for efficiently transmitting thermal stimulation from the thermoelectric conversion elements 2 to a tactile presentation target site of the user U. Moreover, setting such thermal conductivity can provide favorable heat dispersion in the surface of the expansion film, and the plurality of thermoelectric conversion elements 2 easily presents a warm or cold sensation to the entire tactile presentation target site.

In a case where two expansion films are provided as in the presentation unit 9 according to the second embodiment, the thermal conductivity of the second expansion film 12 of the two expansion films, which is positioned on the non-skin side, is favorably 0.2 W/mK or more because the second expansion film 12 functions as the heat dissipation portion.

A polymeric membrane containing carbon, carbon nanotube, or the like may be used as the expansion film for enhancing the thermal conductivity.

### [Dimension(s) of Expansion Film(s)]

The dimension of the expansion film 1 (or the first expansion film 11 and the second expansion film 12) in a planar view can be set as appropriate depending on a tactile presentation target site. For example, a diameter a of an expansion film 1 (first expansion film 11 and second expansion film 12) in a substantially perfect circle shape is 30 mm in a case where the tactile presentation target site is a hand finger tip as shown in Fig. 1 (B). For example, a major axis e of an elliptical expansion film 1 (first expansion film 11 and second expansion film 12) is 70 mm and a minor axis f is 30 mm in a case where the tactile presentation target site is a palm as shown in Fig. 9 (B).

### [Dimension Example of Thermoelectric Conversion Element]

The dimension of the thermoelectric conversion element 2 can be set as appropriate depending on a tactile presentation target site. For example, vertical and horizontal dimensions of the thermoelectric conversion element, which is typically rectangular, are favorably set to be a size that does not easily cause discomfort to the user U due to the presence of corners of the thermoelectric conversion element when the expansion film expands. Since the sensitivity differs depending on a body site, the size that does not easily cause discomfort also differs.

A vertical dimension b and a horizontal dimension c of the thermoelectric conversion element 2 are each favorably 6 mm or less in a case where the tactile presentation target site is a hand finger tip as shown in Fig. 1 (B) because it does not easily cause discomfort to the user U due to the presence of the corners of the thermoelectric conversion element. A vertical dimension g and the horizontal dimension c of the thermoelectric conversion element 2 are each favorably 10 mm or less in a case where the tactile presentation target site is a palm as shown in Fig. 9 (B). The vertical dimension g and the horizontal dimension c of the thermoelectric conversion element 2 are each favorably 20 mm or less in a case where the tactile presentation target site is a forearm.

### [Arrangement Example of Thermoelectric Conversion Elements]

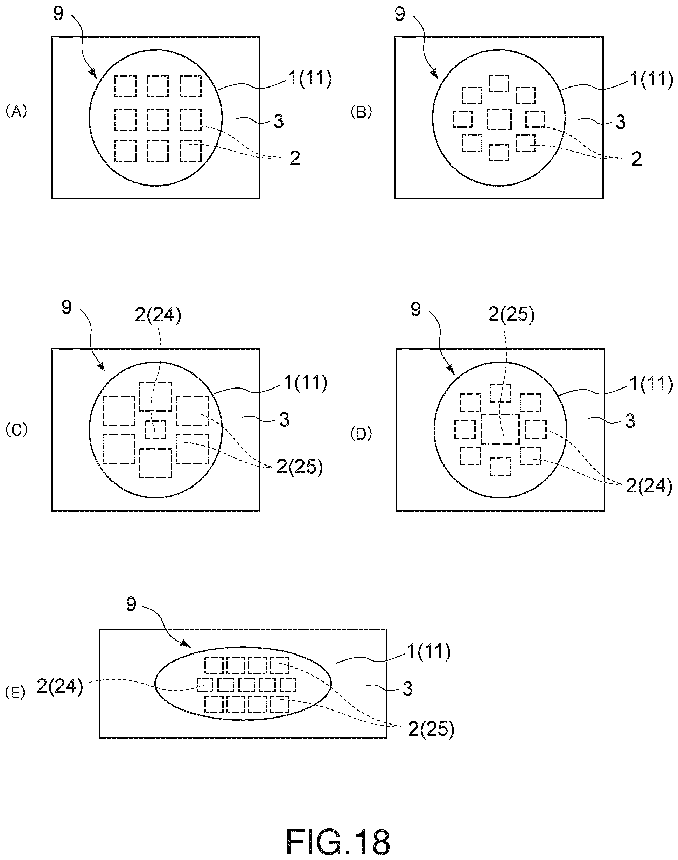

In each of the first and second embodiments, the number of thermoelectric conversion elements 2 and the arrangement of the thermoelectric conversion elements 2 are not limited to the forms shown in Fig. 1 (B) and Fig. 9 (B). Moreover, the number of thermoelectric conversion elements 2 and the arrangement of the thermoelectric conversion elements 2 can be set as appropriate depending on a tactile presentation target site. Hereinafter, an example of arrangement will be described with reference to Fig. 18. Each view of Fig. 18 is a plan view of the tactile presentation apparatus.

As shown in Fig. 18 (A), three (vertical) and three (horizontal), a total of nine thermoelectric conversion elements 2 may be arranged in the form of a grid.

As shown in Fig. 18 (B) to (D), the thermoelectric conversion elements 2 may be arranged at substantially the center of the expansion film 1 (first expansion film 11) having a substantially circle shape in a planar view and the plurality of thermoelectric conversion elements 2 may be arranged surrounding the central thermoelectric conversion element 2. The thermoelectric conversion element 2 positioned surrounding the central thermoelectric conversion element 2 may be arranged on a substantially concentric circle having the center of the expansion film 1 (first expansion film 11) as its center, for example.

In an expansion film having a substantially perfect circle shape, there is a tendency that during expansion, the expansion film has a curved surface, the center portion has a larger curvature of the curved surface, the peripheral portion has a smaller curvature, and the curvature becomes smaller toward the circumference in the radial direction from the center portion. Therefore, the plurality of thermoelectric conversion elements 2 positioned surrounding the central thermoelectric conversion element 2 is arranged on the concentric circle having the center of the expansion film as its center and is arranged on the curved surface having substantially the same curvature during expansion. Accordingly, a non-uniform distribution of deformation due to expansion does not easily occur in the expansion film surface on which the thermoelectric conversion elements 2 are arranged and the entire expansion film can be deformed in a more natural shape during expansion.

As shown in Fig. 18 (A) and (B), the plurality of thermoelectric conversion elements 2 may have the same size, in other words, the contact areas of the expansion film with the thermoelectric conversion elements may be the same among the plurality of thermoelectric conversion elements 2.

Moreover, as shown in Fig. 18 (C) to (E), the thermoelectric conversion element 2 may have different sizes, in other words, the contact areas of the expansion film with the thermoelectric conversion elements may be configured to be different among the plurality of thermoelectric conversion elements 2. In Fig. 18 (C) to (E), the thermoelectric conversion elements with a relatively smaller size will be denoted by the reference sign 24 and the thermoelectric conversion elements with a relatively larger size will be denoted by the reference sign 25. It should be noted that although the example of using two types of thermoelectric conversion elements different in dimension is shown in Fig. 18 (C) to (E), three or more types of thermoelectric conversion elements different from each other in dimension may be used. Moreover, the number of various types of thermoelectric conversion elements can be one or more.

In Fig. 18 (C), the thermoelectric conversion element 2 positioned at the center has a relatively smaller size and the plurality of thermoelectric conversion elements 2 positioned surrounding this thermoelectric conversion element 2 positioned at the center has a relatively larger size.

In Fig. 18 (D), the size of the thermoelectric conversion element 2 positioned at the center is relatively larger and the size of each of the plurality of thermoelectric conversion elements 2 positioned surrounding this thermoelectric conversion element 2 positioned at the center is relatively smaller.

Here, there is a tendency that during expansion, the expansion film has a curved surface, the center portion has a larger curvature of the curved surface, and the peripheral portion has a smaller curvature. Therefore, in a case of using the thermoelectric conversion elements 2 with different sizes, it is more favorable to set the size of the thermoelectric conversion element 2 positioned at the center portion having a larger curvature during expansion to be relatively smaller and set the size of each of the thermoelectric conversion elements 2 positioned at the peripheral portion having a smaller curvature during expansion to be relatively larger as shown in Fig. 18 (B). Accordingly, a non-uniform distribution of deformation due to expansion does not easily occur in the expansion film surface on which the thermoelectric conversion elements 2 are arranged and the entire expansion film can be deformed in a more natural shape during expansion.

Fig. 18 (E) shows an example of arrangement of the thermoelectric conversion elements in the tactile presentation apparatus 2 including the cylindrical support 3 shown in Fig. 9.

Fig. 9 (B) shows the example in which the two thermoelectric conversion elements 2 are separately arranged in the longitudinal direction of the expansion film 1 (first expansion film 11) on the elliptical expansion film 1 (first expansion film 11) in a planar view.

As shown in Fig. 18 (E), the three or more thermoelectric conversion elements 2 may be provided. Moreover, as shown in the figure, a plurality of (three in the figure) thermoelectric conversion element groups each having the plurality of thermoelectric conversion elements 2 separately arranged in the longitudinal direction may be arranged in a short-side direction, spaced apart from each other. Moreover, as shown in the figure, the size of each of five thermoelectric conversion elements 2 that constitute the thermoelectric conversion element group positioned at the center in the short-side direction may be configured to be smaller than the size of each of four thermoelectric conversion elements 2 that constitute each of the thermoelectric conversion element groups positioned on both sides or vice versa. Moreover, the thermoelectric conversion elements 2 may all have the same size.

In the substantially elliptical expansion film, there is a tendency that the expansion film has a curved surface and the center portion in each of the short-side direction and the longitudinal direction has a larger curvature of the curved surface as compared to the both side portions during expansion. It is favorable to arrange relatively smaller thermoelectric conversion elements in a region having a relatively larger curvature of the curved surface and arrange relatively larger thermoelectric conversion elements in a region having a relatively smaller curvature of the curved surface. Accordingly, a non-uniform distribution of deformation due to expansion does not easily occur in the expansion film surface on which the thermoelectric conversion elements 2 are arranged and the entire expansion film can be deformed in a more natural shape during expansion.

As described above, the thermoelectric conversion elements may have different sizes in accordance with magnitudes of the curvature of the curved surface on the expansion film during expansion. The entire expansion film can be deformed in a more natural shape during expansion even with the arranged thermoelectric conversion elements. Pressure stimulation by expansion of the expansion film can be thus favorable.

The distance between the adjacent thermoelectric conversion elements 2, e.g., a distance d shown in Fig. 1 (B) or a distance I shown in Fig. 9(B), is favorably set to be in a range lower than the thermal threshold at a spatial distance between two points. Accordingly, a sensation of receiving thermal stimulation separately from the adjacent thermoelectric conversion elements is not easily presented, and the plurality of thermoelectric conversion elements 2 can achieve natural thermal presentation that would cause no discomfort in a wide area.

The thermal threshold varies depending on a body site. Therefore, the arrangement intervals of the thermoelectric conversion elements can be set as appropriate in accordance with a site that is the tactile presentation target.

For example, the distance d between the adjacent thermoelectric conversion elements 2 is favorably set to be about 3 mm or less in a case where the tactile presentation target site is a hand finger tip as shown in Fig. 1 (B). The distance i between the adjacent thermoelectric conversion elements 2 is favorably set to be about 10 mm or less in a case where the tactile presentation target site is a palm as shown in Fig. 9(B). Moreover, the distance between the adjacent thermoelectric conversion elements 2 is favorably set to be about 20 mm or less in a case where the tactile presentation target site is a forearm.

### [Arrangement Region Area of Thermoelectric Conversion Elements]

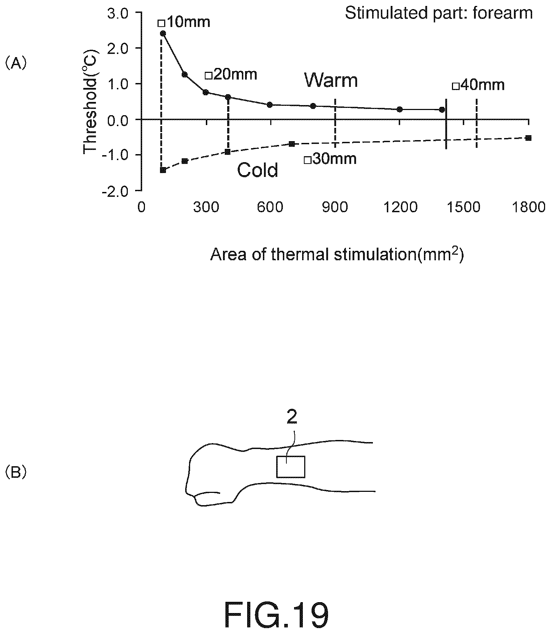

In order to present warmness/coldness with a smaller temperature change, it is favorable to set a lower limit area for an arrangement region in which the plurality of thermoelectric conversion elements is arranged. Hereinafter, the description will be given with reference to Fig. 19.

It should be noted that the arrangement region means a region surrounding all the plurality of thermoelectric conversion elements arranged on the expansion film. In a case where the thermoelectric conversion elements are separately arranged on the expansion film, the arrangement region includes an arrangement region in which the thermoelectric conversion elements are arranged and a non-arrangement region in which no thermoelectric conversion elements are arranged. For example, in the example shown in Fig. 1 (B), the arrangement region is a cross shape. In Fig. 18 (A), the arrangement region has a square shape. In the example shown in Fig. 18 (B) to (D), the arrangement region has a substantially perfect circle shape.

Fig. 19 (A) is a diagram showing a relationship between a threshold for feeling a temperature change and an area of the thermoelectric conversion element in a case where the tactile presentation target site is a forearm.

As shown in Fig. 19 (B), the thermoelectric conversion element 2 is placed on the forearm of a tactile presentation target person and left as it is for a while. Accordingly, the temperature of the thermoelectric conversion element 2 becomes the same as the skin temperature of the forearm of the tactile presentation target person. The temperature at this time will be referred to as a reference temperature. The temperature of the thermoelectric conversion element 2 is measured when the tactile presentation target person feels that it is warm or cold while supplying the thermoelectric conversion element 2 with electric power from the state at the reference temperature and applying a warm or cold stimulation to the tactile presentation target person. A difference between the measured temperature and the reference temperature is defined as the threshold for feeling a temperature change. A plurality of square thermoelectric conversion elements different in size was prepared and the threshold for feeling a temperature change was measured for each thermoelectric conversion element. Fig. 19 (A) shows results of such measurement. In the figure, 10 mm, 20 mm, or the like represents the length of one side of the thermoelectric conversion element.

As shown in Fig. 19 (A), as to the warm sensation, the threshold for feeling a temperature change sharply decreases until the plane area of the thermoelectric conversion element becomes 400 mm² from 100 mm², gently decreases after that, and does not easily change beyond 900 mm². Moreover, substantially the same behaviors are found also as to the cold sensation. In this manner, the threshold for feeling a temperature change decreases with an increase in presentation area. It can thus be said that the target person becomes more sensitive to warmness/coldness with an increase in contact area of the skin with the thermoelectric conversion element.

Moreover, the threshold for feeling substantially the same temperature change as in a case where the size of the single thermoelectric conversion element equals the first area can be obtained as long as the total area of the plurality of thermoelectric conversion elements is equal to or higher than 70% of the first area (arrangement region area), for example, also in a case where the plurality of thermoelectric conversion elements is separately arranged in the arrangement region of the first area.

That is, although Fig. 19 (A) shows the relationship between the area of the single thermoelectric conversion element and the threshold for feeling a temperature change, the relationship between the area of the arrangement region in which the plurality of thermoelectric conversion elements is arranged and the threshold for feeling a temperature change also exhibits a substantially similar tendency to that of Fig. 19 as long as the total area of the plurality of thermoelectric conversion elements is equal to or higher than 70% of the arrangement region area.

As shown in Fig. 19 (A), in a case where the tactile presentation target site is a forearm, setting the area of the arrangement region in which the plurality of thermoelectric conversion elements is arranged to be equal to or larger than 400 mm² enables warmness/coldness to be presented with a smaller temperature change and the power consumption can be reduced.

A favorable area of the arrangement region in which the plurality of thermoelectric conversion elements is arranged differs depending on the tactile presentation target site. However, at any site, the target person tends to be more sensitive to warmness/coldness with an increase in contact area of the skin with the thermoelectric conversion element as in the forearm. Moreover, behaviors similar to the behaviors shown in Fig. 19 are found also at sites other than the forearm as to the relationship between the threshold for feeling a temperature change and the area of the thermoelectric conversion element.

In order to present warmness/coldness with a smaller temperature change, it is favorable to set the area of the arrangement region in which the plurality of thermoelectric conversion elements is arranged, in other words, a contact area with which all the plurality of thermoelectric conversion elements is in contact with the skin to be equal to or lower than 50% of the threshold for feeling a temperature change regarding the warm sensation measured in a reference thermoelectric conversion element, which is a thermoelectric conversion element that is the largest in area among the plurality of thermoelectric conversion elements 2 in the single presentation unit 9.

It should be noted that why the threshold for feeling a temperature change regarding the warm sensation is used as the reference here is because a change in the threshold for feeling a temperature change with respect to the contact area regarding the warm sensation tends to be generally smaller as compared to the cold sensation as shown in Fig. 19. Calculating a suitable arrangement region area using the threshold for feeling a temperature change regarding the warm sensation as the reference can provide a suitable arrangement region area for presenting a cold sensation with a smaller temperature change also regarding the cold sensation.

In a case where the tactile presentation target site is a finger tip, setting the area of the arrangement region in which the plurality of thermoelectric conversion elements is arranged to be equal to or larger than 100 mm² enables warmness/coldness to be presented with a smaller temperature change.

In a case where the tactile presentation target site is a palm, setting the area of the arrangement region in which the plurality of thermoelectric conversion elements is arranged to be equal to or larger than 200 mm² enables warmness/coldness to be presented with a smaller temperature change.

Setting the lower limit area for the arrangement region in which the plurality of thermoelectric conversion elements is arranged in this manner enables warmness/coldness to be presented with a smaller temperature change. Accordingly, effective thermal presentation can be achieved with lower power consumption.

### <Control Examples of Thermoelectric Conversion Element>

Hereinafter, control examples will be described. Two or more of the control examples described below may be combined. These control examples can achieve a wider variety of tactile presentation.

### [Control Example 1]

In the presentation unit 9, the plurality of thermoelectric conversion elements 2 may be controlled at once or may be individually controlled. Hereinafter, the example in which the plurality of thermoelectric conversion elements 2 is individually controlled will be described with reference to Fig. 1 (B), Fig. 4 (A) and (B), and Fig. 20.

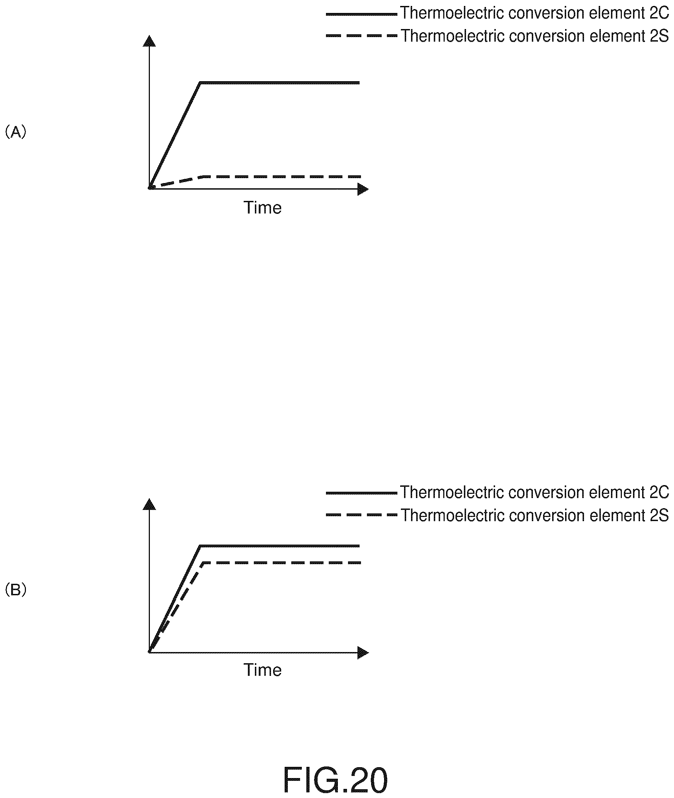

Fig. 20 (A) and (B) show changes over time in electric power supplied to a thermoelectric conversion element 2C (in the figure, shown as the solid line) and a thermoelectric conversion element 2S (in the figure, shown as the broken line).

As described above, as shown in Fig. 1 (B) and Fig. 4 (A), the abdomen of the finger tip of the user U is positioned in contact with the three thermoelectric conversion elements 2C positioned at the center in the X-axis direction via the expansion film 1 in a state in which the expansion film 1 has contracted before the inflow of the fluid. In such a case, as shown in Fig. 20 (A), the thermoelectric conversion element 2C in contact with the finger tip is controlled to be supplied with electric power to apply thermal stimulation to the user U. On the other hand, the thermoelectric conversion element 2S does not need to apply thermal stimulation because they are not in contact with the finger tip. Therefore, the thermoelectric conversion element 2S is not controlled. It should be noted that Fig. 20 (A) shows that the thermoelectric conversion element 2S is slightly supplied with electric power for the sake of convenience.

As shown in Fig. 1 (B) and Fig. 4 (B), in a state in which the expansion film 1 has expanded by the inflow of the fluid, the abdomen and the lateral portions of the finger of the user U are held in contact with the three thermoelectric conversion elements 2C positioned at the center portion in the X-axis direction and the two thermoelectric conversion elements 2S positioned at both side portions in the X-axis direction via the expansion film 1. In such a case, as shown in Fig. 20 (B), the thermoelectric conversion elements 2C and 2S in contact with the finger tip are supplied with electric power and controlled to apply thermal stimulation to the user U. It should be noted that as shown in Fig. 20 (B), the electric power supply may be performed so that the electric power supply amount to the thermoelectric conversion element 2C and the electric power supply amount to the thermoelectric conversion element 2S are different from each other or the electric power supply may be performed with the same electric power supply amount for the thermoelectric conversion element 2C and the thermoelectric conversion element 2S.

As shown in Fig. 4 (A) and (B), when the contact area of the finger tip with the expansion film 1 changes in accordance with the form of the expansion film 1, a necessary thermal presentation area also changes. Individually controlling the plurality of thermoelectric conversion elements 2 can selectively control only thermoelectric conversion element(s) that is in contact with the finger tip and required to be driven for thermal stimulation in accordance with the form of the expansion film 1. Accordingly, the thermal presentation can be effectively performed and the power consumption can be reduced.

### [Control Example 2]

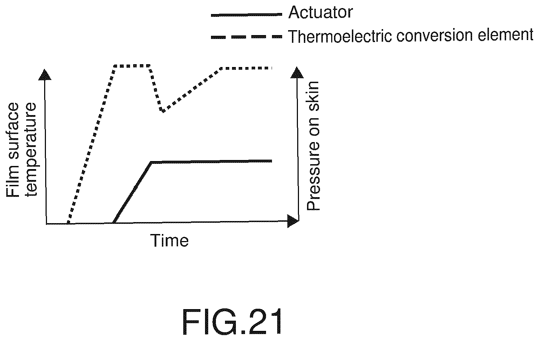

In a case of applying pressure stimulation and thermal stimulation, electric power may be input to the thermoelectric conversion element 2 in the presentation unit 9 for driving the thermoelectric conversion element 2 before the actuator 5 is driven for causing a fluid to flow in the space. Fig. 21 is a diagram describing a timing difference between a control signal (shown as the broken line) of the thermoelectric conversion element and a driving control signal (shown as the solid line) of the actuator.

A time from supply of electric power to the thermoelectric conversion element to transmission of heat dissipation or heat absorption by the above-mentioned electric power supply to the skin of the user U via the expansion film tends to be longer than a time from driving of the actuator to presentation of pressure stimulation by expansion of the expansion film to the user U. Moreover, adaptation speed to a warm sensation is lower while adaptation speed to a pressure sensation is higher. Therefore, it is favorable that electric power is first input to the thermoelectric conversion element. Accordingly, desired pressure stimulation and desired thermal stimulation can be substantially simultaneously presented to the user U.

### [Control Example 3]

The thermoelectric conversion element may be driven and controlled to change the temperature rise/temperature drop rate in a range of 0 ±10 °C/sec. Changing the temperature rise/temperature drop rate can change the level of thermal stimulation presented to the user, and a variety of tactile senses can be presented.

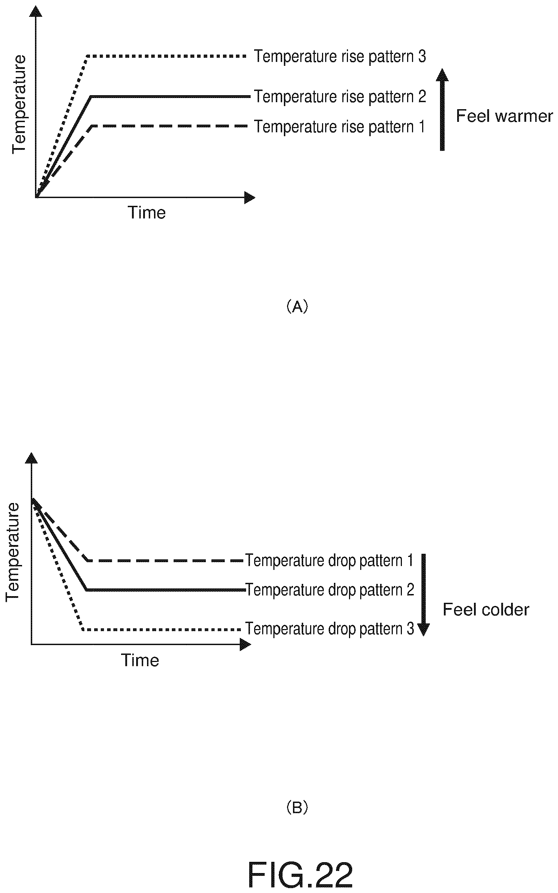

Fig. 22 (A) shows an example of a temperature rise pattern. In the figure, the temperature rise rate increases in the order of a temperature rise pattern 1, a temperature rise pattern 2, and a temperature rise pattern 3. The user U feels warmer as an illusion with an increase in temperature rise rate.

Fig. 22 (B) shows an example of a temperature drop pattern. In the figure, the temperature drop rate increases in the order of a temperature drop pattern 1, a temperature drop pattern 2, and a temperature drop pattern 3. The user U feels cooler as an illusion with an increase in temperature drop rate.

### [Control Example 4]

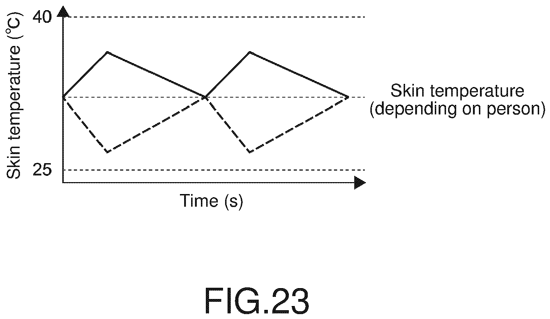

Fig. 23 shows a control example of the thermoelectric conversion elements for keeping a warm or cold sensation as a sensation that the user U actually feels. The solid line represents a control signal example for keeping a warm sensation and the broken line represents a control signal example for keeping a cold sensation.

Here, humans become adapted to warm stimulation so that they are not aware anymore of the warm stimulation when continuously performing warm stimulation to the skin. Moreover, the same phenomenon occurs also as to cold stimulation. The following control is favorably performed in order to avoid the phenomenon that humans cannot continuously feel a warm or cold sensation due to such adaptation.

In order to keep a warm sensation, the thermoelectric conversion element is favorably controlled as follows as shown as the solid line in Fig. 23.

That is, after the temperature of the thermoelectric conversion element is increased to an arbitrary temperature at a first temperature rise rate, the temperature is lowered at a speed equal to or lower than 1/2 of the first temperature rise rate. Then, once the temperature of the thermoelectric conversion element becomes in a range of the skin temperature of the user ±1°C, it is controlled to increase the temperature again. Repeating this operation can avoid the phenomenon that skin is adapted to warm stimulation so that the user is not aware anymore of the warm stimulation. Accordingly, a warm sensation can be continuously presented, though the user can sometimes feel warm stimulation discontinuously. It should be noted that the skin temperature of the user is measured by the thermal sensor arranged on the expansion film 1 in advance before the presentation unit 9 is used. Moreover, an arbitrary temperature can be set as appropriate depending on a skin temperature of the user.

In order to keep a cold sensation, the thermoelectric conversion element is favorably controlled as follows as shown as the broken line in Fig. 23.

That is, after the temperature of the thermoelectric conversion element is lowered to an arbitrary temperature at a first temperature drop rate, the temperature is increased at a speed equal to or lower than 1/2 of the first temperature drop rate. Then, once the temperature of the thermoelectric conversion element becomes in a range of the skin temperature of the user ±1°C, it is controlled to lower the temperature again. Repeating this operation can avoid the phenomenon that skin is adapted to cold stimulation so that the user is not aware anymore of the cold stimulation. Accordingly, a cold sensation can be continuously presented, though the user can sometimes feel cold stimulation discontinuously. It should be noted that the skin temperature of the user is measured by the thermal sensor arranged on the expansion film 1 in advance before the presentation unit 9 is used. It should be noted that the skin temperature of the user is measured by the thermal sensor arranged on the expansion film 1 in advance before the presentation unit 9 is used. Moreover, an arbitrary temperature can be set as appropriate depending on a skin temperature of the user.

Controlling the input electric power of the thermoelectric conversion element to change in this manner enables continuous presentation of a warm or cold sensation as described above and power consumption reduction. Moreover, heat dissipation structures including a heat sink, a cooling fan, and the like become unnecessary.

### [Control Example 5]

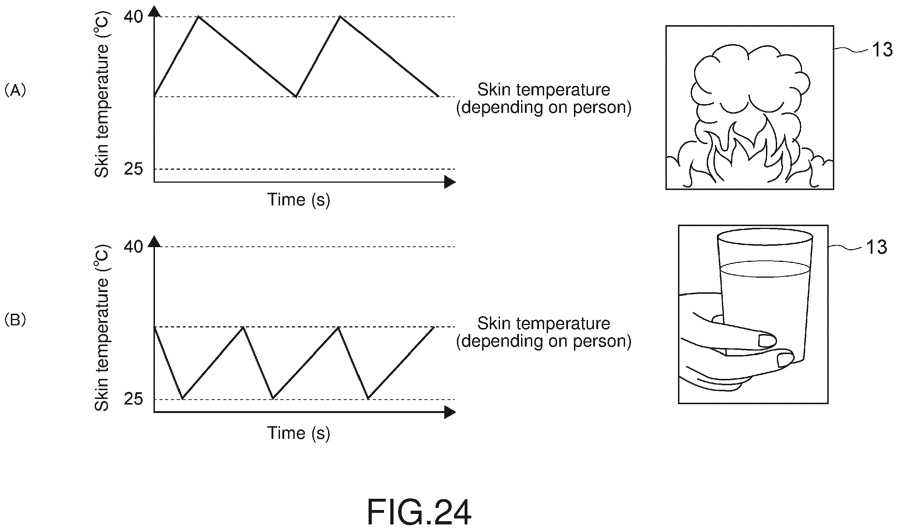

Fig. 24 is a diagram describing an example of presenting warmness/coldness according to a video displayed on the display 13. Fig. 24 (A) is a control signal example of the thermoelectric conversion element for presenting heat generated by an explosion displayed on the display 13. Fig. 24 (B) is a control signal example of the thermoelectric conversion element for presenting coldness when holding a glass containing cold water displayed on the display 13. In both Fig. 24(A) and (B), the control described above in Control Example 4 can be performed for continuously presenting warm and cold sensations to the user.

### [Basic Control Method for Presentation Unit]

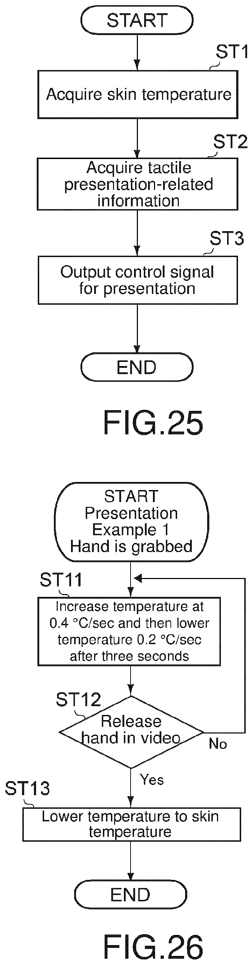

A basic flow of a control method for the presentation unit 9 will be described with reference to Fig. 25. Controlling the presentation unit 9 performs tactile presentation. In the tactile presentation apparatus, the control unit 6 controls the presentation unit 9.

As shown in Fig. 25, the control unit 6 acquires temperature information of the expansion film detected by the thermal sensor 18 and estimates a skin temperature of the user on the basis of the temperature information (ST1).

Next, the control unit 6 acquires tactile presentation-related information (ST2). This tactile presentation-related information is, for example, a pressure value and a temperature value detected by the tactile presentation apparatus in the above-mentioned first application example and a pressure value detected by the tactile presentation apparatus in the above-mentioned second application example. Moreover, in the above-mentioned third to fifth application examples, the tactile presentation-related information is information according to the video and includes thermal stimulation-related information and pressure stimulation-related information.

Next, the control unit 6 calculates a driving signal for the thermoelectric conversion element 2 and a driving signal for the actuator 5 on the basis of the skin temperature of the user and the tactile presentation-related information and outputs the driving signals to the thermoelectric conversion element 2 and the actuator 5 (ST3). The control unit 6 calculates a driving signal according to a sensation to be expressed, for example, a sensation as if the hand was grabbed, a sensation as if an explosion occurred, or a sensation as if the user touched a teacup containing hot tea.

The thermoelectric conversion element 2 and the actuator 5 are driven on the basis of the driving signals. Accordingly, pressure stimulation and thermal stimulation are presented to the user.

### [Specific Tactile Presentation Example]

Next, specific control examples of the thermoelectric conversion elements according to the above-mentioned application examples will be described with reference to Figs. 26 to 28. It should be noted that here, the description of driving of the actuator will be omitted.

### (Presentation Example 1)

Fig. 26 is an example showing an example presenting a sensation as if the hand was grabbed.

The control unit 6 drives the thermoelectric conversion elements 2 as an expression of a sensation as if the hand was grabbed on the basis of a driving signal with a control pattern to increase the temperature at 0.4 °C/sec and then lower the temperature 0.2 °C/sec after three seconds (ST11). At this time, it is assumed that a video in which the wrist is grabbed by a virtual person is displayed to the user U on the display 13.

Next, the control unit 6 determines whether or not the virtual person has released his/her hand from the wrist in the video (ST12). In a case where the control unit 6 determines that the virtual person has released his/her hand from the wrist (YES), the control unit 6 controls the thermoelectric conversion elements 2 to lower the temperature to the skin temperature (ST13) and the processing is terminated. On the other hand, in a case where the control unit 6 determines that the virtual person has not released his/her hand from the wrist, the processing is returned to ST11 and repeated.

### (Presentation Example 2)

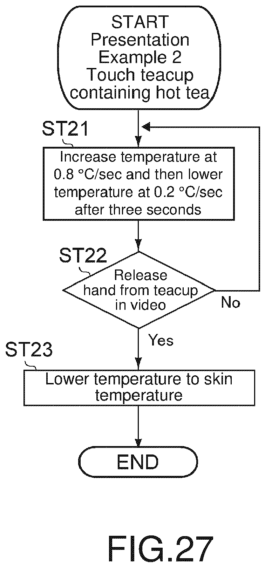

Fig. 27 is an example showing an example presenting a sensation as if the user touched the teacup containing hot tea.

The control unit 6 drives the thermoelectric conversion elements 2 as an expression of the explosion sensation on the basis of a driving signal with a control pattern to increase the temperature at 0.8 °C/sec and then lower the temperature at 0.2 °C/sec after three seconds (ST21). At this time, it is assumed that a video in which the user holds the teacup containing hot tea in the hand is displayed to the user U on the display 13.

Next, the control unit 6 determines whether or not the user has released his/her hand from the teacup in the video (ST22). In a case where the control unit 6 determines that the user has released his/her hand from the teacup in the video (YES), the control unit 6 controls the thermoelectric conversion elements 2 to lower the temperature to the skin temperature (ST23) and the processing is terminated. On the other hand, in a case where the control unit 6 determines that the user has not released his/her hand from the teacup in the video, the processing is repeated to ST21 and repeated.

### (Presentation Example 3)

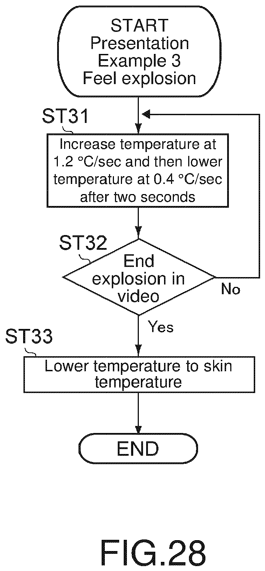

Fig. 28 is an example showing an example presenting an explosion sensation.

The control unit 6 drives the thermoelectric conversion elements as an expression of the explosion sensation on the basis of a driving signal with a control pattern to increase the temperature at 1.2 °C/sec and then lower the temperature at 0.4 °C/sec after two seconds (ST31). At this time, it is assumed that a video of the explosion is displayed to the user U on the display 13.

Next, the control unit 6 determines whether or not the explosion has ended in the video (ST32). In a case where the control unit 6 determines that the explosion has ended (YES), the control unit 6 controls the thermoelectric conversion elements 2 to lower the temperature to the skin temperature (ST33). On the other hand, in a case where the control unit 6 determines that the virtual person has not released his/her hand from the wrist, the processing is returned to ST31 and repeated.

The control patterns in the thermoelectric conversion elements described in Presentation Examples 1 to 3 may be generated as a database in advance, associated with each of the types of thermal sensation stimuli expressed by the thermoelectric conversion elements, such as a sensation as if the hand was grabbed, a sensation as if the user held the teacup containing hot tea, and a sensation as if the explosion occurred. Then, the control pattern may be read from the database in accordance with the video contents and the thermoelectric conversion elements may be controlled on the basis of the control pattern.

### <Supplements>

Although the embodiments of the present invention have been described above, the present invention is not limited to these embodiments, and various modifications can be made without departing from the gist of the present invention as a matter of course. For example, configurations as in Modified Examples 1 to 3 below may be employed.

### [Modified Example 1]

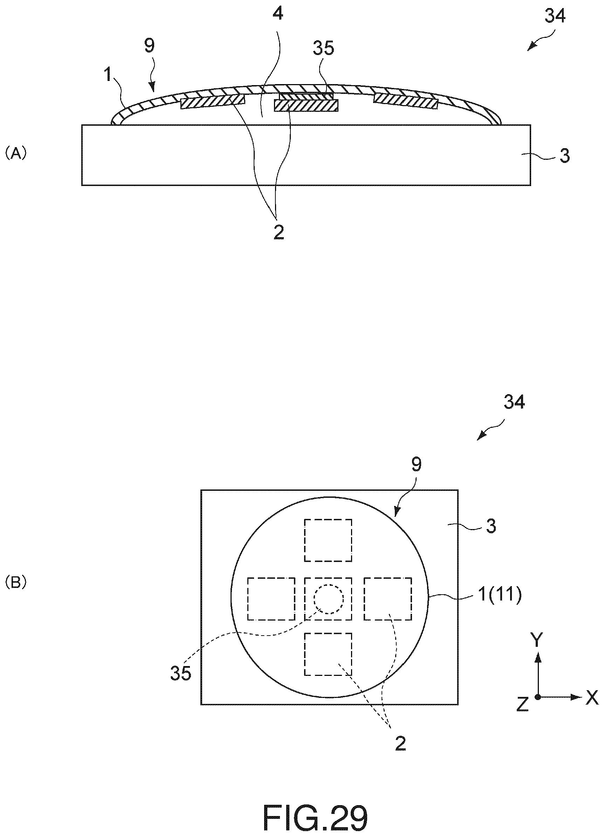

A tactile presentation apparatus 34 according to a modified example will be described with reference to Fig. 29.

Fig. 29 (A) is a schematic cross-sectional view showing a configuration of the tactile presentation apparatus 34. Fig. 29 (B) is a schematic plan view of the tactile presentation apparatus 34 in Fig. 29 (A) as viewed from above.

As shown in Fig. 29 (A) and (B), a thin plate-like heat spreader 35 may be provided between the thermoelectric conversion element 2 positioned at the center and the expansion film 1.

The heat spreader 35 has a disk shape having a smaller plane area than the thermoelectric conversion element 2 so that the heat spreader 35 is positioned in the thermoelectric conversion element 2 in a planar view. The heat spreader 35 is constituted by a metal having high thermal conductivity, such as copper and aluminum, ceramics such as aluminum nitride and silicon nitride, and the like. Constituting the heat spreader 35 by the material having high thermal conductivity enables thermal stimulation by the thermoelectric conversion element 2 to be efficiently transmitted to a tactile presentation target site of the user U.

Here, the thermoelectric conversion element has a polygonal shape such as typically a square shape and a rectangular shape. Therefore, tension is applied on portions of the expansion film corresponding to the corner portions of the thermoelectric conversion elements during expansion on the expansion film on which the thermoelectric conversion elements are adhered and arranged, and they may be ripped.

In this regard, the disk-like heat spreader 35 is provided between the expansion film 1 and the thermoelectric conversion element in the tactile presentation apparatus 34 and the disk-like heat spreader 35 has no corners. Therefore, the expansion film is not easily ripped by locally applying tension on the expansion film. This can provide the presentation unit 9 excellent in the durability.

### [Modified Example 2]

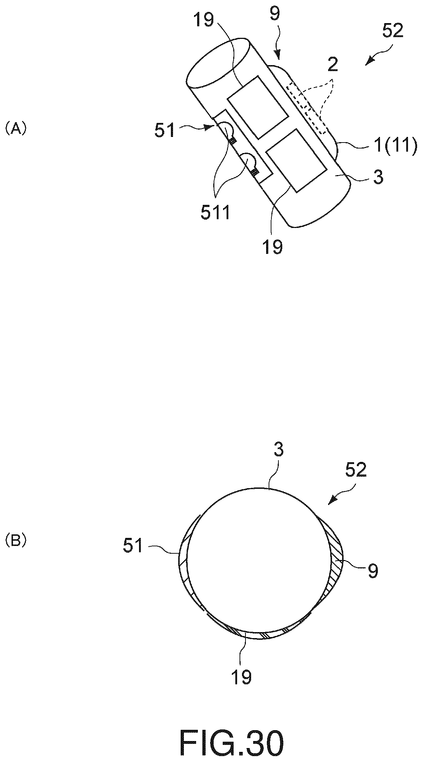

A tactile presentation apparatus 52 according to a modified example will be described with reference to Fig. 30.

Fig. 30 (A) is a perspective view showing a configuration of the tactile presentation apparatus 52. Fig. 30 (B) is a diagram of the tactile presentation apparatus 52 shown in Fig. 30 (A) as viewed in a direction parallel to the longitudinal direction.

As shown in Fig. 30 (A) and (B), the tactile presentation apparatus 52 includes a cylindrical support 3, a detection unit 51 with a pressure sensor 511, a presentation unit 9, and two thermoelectric conversion elements 19.

The detection unit 51, the presentation unit 9 and the thermoelectric conversion elements 19 are provided on the support 3 and provided at different positions. For example, as shown in Fig. 30 (B), the detection unit 51 and the presentation unit 9 are positioned substantially in opposite to each other via the support 3. The two thermoelectric conversion elements 19 are positioned between the detection unit 51 and the presentation unit 9 along the peripheral portion of the cylindrical support 3. The thermoelectric conversion elements 19 may be flexibly-deformable flexible thermoelectric conversion elements or may be generally-used thermoelectric conversion elements with ceramic substrates. It should be noted that the thermoelectric conversion elements are favorably flexible thermoelectric conversion elements easy to be arranged along the curved surface because they are arranged on the support 3 having the curved surface. A configuration example of the thermoelectric conversion elements will be described later.

In the example shown in Fig. 30, when the user U grabs the tactile presentation apparatus 52, the detection unit 51 is provided at a position corresponding to a region from the DIP joint to the finger tip of each of the index finger, the middle finger, the ring finger, and the little finger. The presentation unit 9 is provided at a position corresponding to the palm (center of the palm) when the user grabs the tactile presentation apparatus 52. The thermoelectric conversion elements 19 are provided at a position corresponding to the vicinity of the roots of the index finger, the middle finger, the ring finger, and the little finger when the user grabs the tactile presentation apparatus 52.

In this manner, the tactile presentation apparatus 52 may be configured to have the thermoelectric conversion elements 19 that apply only thermal stimulation in addition to the presentation unit 9 that applies pressure stimulation and thermal stimulation. Accordingly, the presentation area of thermal stimulation can be widened and a warm/cold sensation can be efficiently presented even with a slight temperature change. Moreover, a configuration in which some stimulation such as pressure stimulation and thermal stimulation is presented in the entire palm is achieved. It reduces discomfort caused when stimulation is locally performed.

Moreover, here, the example in which the thermoelectric conversion elements 19 that apply only thermal stimulation are provided in addition to the presentation unit 9 has been described. However, a configuration in which a thin resistance heater is used instead of the thermoelectric conversion elements 19 and warm stimulation is performed with this thin resistance heater may be employed. Accordingly, the presentation area of warm stimulation can be increased using both the presentation unit 9 and the thin resistance heater, and a warm sensation can be efficiently presented even with a slight temperature change.

### [Modified Example 3]

In the second embodiment describing the presentation unit 9 with the two expansion films described above, the example in which the pressure sensation is presented by causing the fluid to flow in or out of the space 4 between the second expansion film 12 and the support 3 has been described, though not limited thereto. It may be capable of causing the fluid to flow in or out of the space between the first expansion film 11 and the second expansion film 12 in addition to causing the fluid to flow in or out of the space 4 between the second expansion film 12 and the support 3. In this case, the second expansion film 12 is adhered to the thermoelectric conversion elements 2. Accordingly, a wider variety of tactile presentation can be achieved.

### [Configuration Example of Thermoelectric Conversion Element (Peltier Device)]

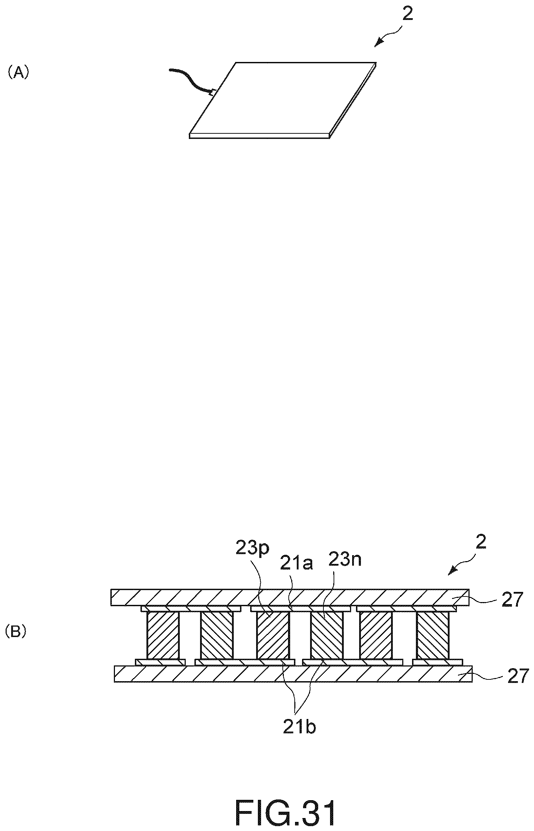

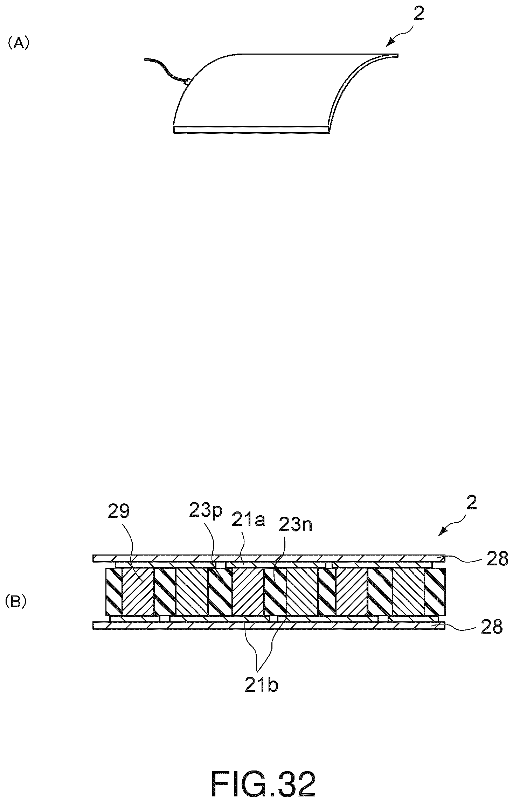

A configuration example of the thermoelectric conversion element will be described with reference to Figs. 31 and 32. In the tactile presentation apparatus according to the present technology, various thermoelectric conversion elements to be described below can be employed. It should be noted that a basic configuration of the thermoelectric conversion element has been described above with respect to Fig. 3.

Fig. 31 (A) and (B) are a perspective view and a schematic cross-sectional view of a generally-used thermoelectric conversion element 2.

As shown in Fig. 31, the generally-used thermoelectric conversion element 2 has two substrates 27 arranged, spaced apart from each other, P-type thermoelectric semiconductors 23p arranged between the two substrates 27, N-type thermoelectric semiconductors 23n, electrodes 21a, and electrodes 21b.

The substrates 27 are constituted by ceramics such as alumina. The substrates 27 made of ceramics has a function of shape retaining, insulation from a cooling target object, and heat dispersion in the surface.

The electrodes 21a and the electrodes 21b are constituted by copper, for example.

The P-type thermoelectric semiconductors 23p and the N-type thermoelectric semiconductors 23n are constituted by Bi-Te based compound semiconductor, for example.

Fig. 32 (A) and (B) are a perspective view and a schematic cross-sectional view of a skeleton-type thermoelectric conversion element 2.

As shown in Fig. 32, the skeleton-type thermoelectric conversion element 2 has two resin films 28 arranged, spaced apart from each other and P-type thermoelectric semiconductors 23p, N-type thermoelectric semiconductors 23n, electrodes 21a, and electrodes 21b, and separators 29 each arranged between the thermoelectric semiconductors, which are arranged between the two resin films 28.

The resin films 28 are provided for insulating a target object from the electrodes in a case where a cooling or heating target object is a conductor, for example. It should be noted that a configuration in which the electrodes are exposed without the resin films 28 may be employed. The skeleton-type thermoelectric conversion element 2 is more easily deformed as compared to the generally-used thermoelectric conversion element 2 using the ceramic substrate.

The electrode 21a and the electrode 21b are constituted by copper, for example.

The P-type thermoelectric semiconductors 23p and the N-type thermoelectric semiconductors 23n are constituted by Bi-Te based compound semiconductor, for example.

The separator 29 is provided for retaining the shape. A soft material may be used as the separator. Moreover, a configuration using no separator may be employed.

A flexible thermoelectric conversion element that is one of skeleton types can have a structure with or without a resin film and the separator is, for example, a rubber and configured to be flexibly deformable.

Moreover, an organic semiconductor may be used as the thermoelectric semiconductor and the flexibility can be further improved and the weight can be reduced.

The present technology can also take the following configurations.
(1) A tactile presentation apparatus, including:
   a support;
   an expansion film that forms a space for retaining a fluid between the expansion film and the support;
   a plurality of thermoelectric conversion elements arranged on a surface of the expansion film, the surface being located on a side of the support; and
   a drive unit that controls inflow/outflow of the fluid.
(2) The tactile presentation apparatus according to (1), in which
   the expansion film includes a first expansion film and a second expansion film positioned closer to the support than the first expansion film,
   the space is formed between the second expansion film and the support, and
   the thermoelectric conversion elements are arranged on a surface of the first expansion film on the side of the support.
(3) The tactile presentation apparatus according to (1) or (2), in which
   at least one of the plurality of thermoelectric conversion elements has a different contact area with the expansion film from a contact area of each of other thermoelectric conversion elements with the expansion film.
(4) The tactile presentation apparatus according to any one of (1) to (3), in which
   the expansion film includes a plurality of expansion films.
(5) The tactile presentation apparatus according to any one of (1) to (4), further including
   at least one of a thermal sensor arranged on the expansion film on which the thermoelectric conversion elements are arranged, a distance sensor arranged in the space, or an air pressure sensor arranged in the space.
(6) The tactile presentation apparatus according to any one of (1) to (5), in which
   the expansion film has thermal conductivity of 0.2 W/mK or more.
(7) The tactile presentation apparatus according to any one of (1) to (6), in which
   the plurality of thermoelectric conversion elements is individually controlled.
(8) The tactile presentation apparatus according to any one of (1) to (7), in which
   the drive unit is controlled to cause the fluid to flow in the space after driving the thermoelectric conversion element.
(9) The tactile presentation apparatus according to any one of (1) to (8), in which
   the thermoelectric conversion element is driven at a temperature rise/temperature drop rate changed in a range of 0 ±10 °C/sec.
(10) The tactile presentation apparatus according to any one of (1) to (9), in which
   the tactile presentation apparatus is arranged so that the expansion film is held in contact with skin of a user, and
   the thermoelectric conversion element is controlled so that a temperature of the thermoelectric conversion element is increased to an arbitrary temperature at a first temperature rise rate and then the temperature of the thermoelectric conversion element is lowered at a speed equal to or lower than 1/2 of the first temperature rise rate, and the temperature of the thermoelectric conversion element is increased after the temperature of the thermoelectric conversion element becomes in a range of a skin temperature of the user ±1°C.
(11) The tactile presentation apparatus according to any one of (1) to (10), in which
   the tactile presentation apparatus is arranged so that the expansion film is held in contact with skin of a user, and
   the thermoelectric conversion element is controlled so that a temperature of the thermoelectric conversion element is lowered to an arbitrary temperature at a first temperature drop rate and then the temperature of the thermoelectric conversion element is increased at a speed equal to or lower than 1/2 of the first temperature drop rate, and the temperature of the thermoelectric conversion element is lowered after the temperature of the thermoelectric conversion element becomes in a range of a skin temperature of the user ±1°C.
(12) The tactile presentation apparatus according to any one of (1) to (11), in which
   the thermoelectric conversion element is driven to apply thermal stimulation according to a video displayed to a user who wears the tactile presentation apparatus.
(13) The tactile presentation apparatus according to any one of (1) to (12), in which
   the thermoelectric conversion element is driven using a control pattern of the thermoelectric conversion element for each type of thermal stimulation expressed by the thermoelectric conversion element, the control pattern being prepared in advance.
(14) A tactile presentation method, including
   controlling driving of a plurality of thermoelectric conversion elements arranged on a surface of an expansion film that forms a space for retaining a fluid between the expansion film and a support and inflow/outflow of the fluid, the surface being located on a side of the support.
(15) A program that causes a computer to execute processing, including
   controlling driving of a plurality of thermoelectric conversion elements arranged on a surface of an expansion film that forms a space for retaining a fluid between the expansion film and a support and inflow/outflow of the fluid, the surface being located on a side of the support.

### Reference Signs List

- 1: expansion film
- 2: thermoelectric conversion element
- 3: support
- 4: space
- 5: actuator (drive unit)
- 10, 30 to 34, 50, 52, 60, 70 to 73: tactile presentation apparatus
- 11: first expansion film
- 12: second expansion film
- 16: distance sensor
- 17: air pressure sensor
- 18: thermal sensor

## Claims

1. A tactile presentation apparatus, comprising:
a support;
an expansion film that forms a space for retaining a fluid between the expansion film and the support;
a plurality of thermoelectric conversion elements arranged on a surface of the expansion film, the surface being located on a side of the support; and
a drive unit that controls inflow/outflow of the fluid.

2. The tactile presentation apparatus according to claim 1, wherein
the expansion film includes a first expansion film and a second expansion film positioned closer to the support than the first expansion film,
the space is formed between the second expansion film and the support, and
the thermoelectric conversion elements are arranged on a surface of the first expansion film on the side of the support.

3. The tactile presentation apparatus according to claim 1, wherein
at least one of the plurality of thermoelectric conversion elements has a different contact area with the expansion film from a contact area of each of other thermoelectric conversion elements with the expansion film.

4. The tactile presentation apparatus according to claim 1, wherein
the expansion film includes a plurality of expansion films.

5. The tactile presentation apparatus according to claim 1, further comprising
at least one of a thermal sensor arranged on the expansion film on which the thermoelectric conversion elements are arranged, a distance sensor arranged in the space, or an air pressure sensor arranged in the space.

6. The tactile presentation apparatus according to claim 1, wherein
the expansion film has thermal conductivity of 0.2 W/mK or more.

7. The tactile presentation apparatus according to claim 1, wherein
the plurality of thermoelectric conversion elements is individually controlled.

8. The tactile presentation apparatus according to claim 1, wherein
the drive unit is controlled to cause the fluid to flow in the space after driving the thermoelectric conversion element.

9. The tactile presentation apparatus according to claim 1, wherein
the thermoelectric conversion element is driven at a temperature rise/temperature drop rate changed in a range of 0 ±10 °C/sec.

10. The tactile presentation apparatus according to claim 1, wherein
the tactile presentation apparatus is arranged so that the expansion film is held in contact with skin of a user, and
the thermoelectric conversion element is controlled so that a temperature of the thermoelectric conversion element is increased to an arbitrary temperature at a first temperature rise rate and then the temperature of the thermoelectric conversion element is lowered at a speed equal to or lower than 1/2 of the first temperature rise rate, and the temperature of the thermoelectric conversion element is increased after the temperature of the thermoelectric conversion element becomes in a range of a skin temperature of the user ±1°C.

11. The tactile presentation apparatus according to claim 1, wherein
the tactile presentation apparatus is arranged so that the expansion film is held in contact with skin of a user, and
the thermoelectric conversion element is controlled so that a temperature of the thermoelectric conversion element is lowered to an arbitrary temperature at a first temperature drop rate and then the temperature of the thermoelectric conversion element is increased at a speed equal to or lower than 1/2 of the first temperature drop rate, and the temperature of the thermoelectric conversion element is lowered after the temperature of the thermoelectric conversion element becomes in a range of a skin temperature of the user ±1°C.

12. The tactile presentation apparatus according to claim 1, wherein
the thermoelectric conversion element is driven to apply thermal stimulation according to a video displayed to a user who wears the tactile presentation apparatus.

13. The tactile presentation apparatus according to claim 1, wherein
the thermoelectric conversion element is driven using a control pattern of the thermoelectric conversion element for each type of thermal stimulation expressed by the thermoelectric conversion element, the control pattern being prepared in advance.

14. A tactile presentation method, comprising
controlling driving of a plurality of thermoelectric conversion elements arranged on a surface of an expansion film that forms a space for retaining a fluid between the expansion film and a support and inflow/outflow of the fluid, the surface being located on a side of the support.

15. A program that causes a computer to execute processing, comprising
controlling driving of a plurality of thermoelectric conversion elements arranged on a surface of an expansion film that forms a space for retaining a fluid between the expansion film and a support and inflow/outflow of the fluid, the surface being located on a side of the support.
